(19) Europäisches Patentamt
European Patent Office
Office européen des brevets

(11) EP 1 667 089 A1

(12) **EUROPEAN PATENT APPLICATION**
published in accordance with Art. 158(3) EPC

(43) Date of publication:
**07.06.2006 Bulletin 2006/23**

(21) Application number: **04771578.4**

(22) Date of filing: **12.08.2004**

(51) Int Cl.:
***G09F 9/30** (1968.09)* ***G09G 3/30** (1980.01)*

(86) International application number:
**PCT/JP2004/011603**

(87) International publication number:
**WO 2005/017859 (24.02.2005 Gazette 2005/08)**

(84) Designated Contracting States:
**DE FR**

(30) Priority: **19.08.2003 JP 2003294919**
**09.02.2004 JP 2004031541**
**20.04.2004 JP 2004123650**
**21.05.2004 JP 2004151202**

(71) Applicant: **FUJI ELECTRIC HOLDINGS CO., LTD.**
**Kawasaki-shi,**
**Kanagawa 210-0856 (JP)**

(72) Inventors:
- **YAMASHIRO, K.,**
**c/o FUJI ELEC. ADV. TECH. CO. LTD.**
**Yokosuka-shi,**
**Kanagawa 240-0194 (JP)**
- **KAWAKAMI, H.,**
**c/o FUJI ELEC. ADV. TECH. CO. LTD.**
**Yokosuka-shi, Kanagawa 240-0194 (JP)**
- **KATO, Hisato,**
**c/o FUJI ELEC. ADV. TECH. CO. LTD.**
**Yokosuka-shi,**
**Kanagawa 240-0194 (JP)**

(74) Representative: **Hoffmann, Eckart**
**Bahnhofstrasse 103**
**82166 Gräfelfing (DE)**

# (54) DISPLAY AND METHOD FOR DRIVING SAME

(57) [Problem] An organic EL display device is matrix-driven by using a two-terminal nonlinear element.

[Means for Resolution] A display device having, on a substrate (102), first stripe electrodes (104), second stripe electrodes (116) disposed crosswise to the first stripe electrodes, and a plurality of pixels disposed at overlaps between the first and second stripe electrodes, each pixel being provided with a switching element (114) including a two-terminal nonlinear element connected electrically to the first stripe electrodes, a light-emitting portion (110) connected electrically to the switching element and the second stripe electrodes, and a capacitor portion (106) containing an organic dielectric material as a dielectric layer, connected electrically to the switching element and the second stripe electrodes in parallel with the light-emitting portion.

FIG. 1

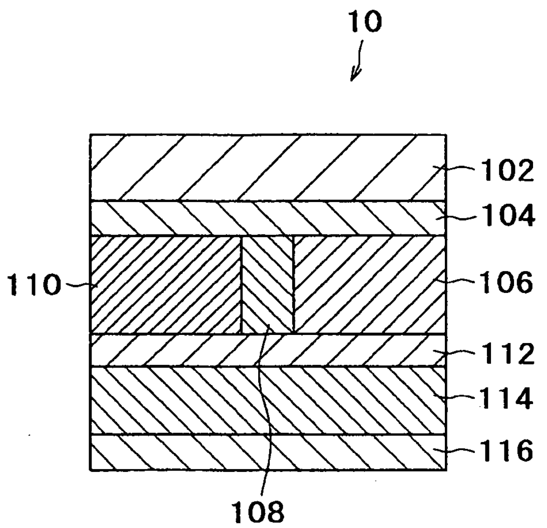


EP 1 667 089 A1

## Description

### Technical Field

The present invention relates to a self-emission display device of an organic EL (electroluminescence) display panel, and a method for driving the display device. More specifically the invention relates to a display device comprising emitting pixels having a matrix structure of a plurality of rows and columns, the pixels being driven by a switching element, and relates to a method for producing the same, and a method for driving a display device.

### Background Art

Recently liquid crystal displays are remarkably spreading as flat displays of information equipments. The liquid crystal displays utilizes an optical shutter function of a liquid crystal for on/off controlling light from a backlight, thereby providing colors using color filters. On the contrary, organic EL displays or organic LED displays have self-emission pixels, and thereby have many advantages in that, for example, they need no color filters and thus have wide viewing angle, they need no backlight and thus can be thinned, and they can be formed on a flexible substrate. Therefore, the organic EL displays are expected as next-generation displays.

Drive systems of the organic EL display panels are classified into 2 types. The first is a so-called passive matrix type drive system (or a duty drive system or a simple matrix system). In this system, a plurality of stripe electrodes are combined into a matrix of rows and columns, pixels are formed at overlaps between each of the row electrodes and each of the column electrodes, and a driving signal is applied to the row electrodes and the column electrodes to emit light. The signal for emission control is generally scanned row by row in the row direction through time, and applied simultaneously to the columns in the same row. In the passive matrix type drive system, each pixel generally has no active elements, and the emission is controlled only by the duty period of each row in the scan period. The second is an active matrix type drive system, which has a switching element in each pixel and can emit light over the row scan period.

The advantages of the active matrix type drive system are described below. Described as an example is the case of making a panel of 100 rows x 150 columns emit light with a display luminance 100 Cd/$m^2$. Essentially each pixel emits light during the whole row scan period in the active matrix type drive system, whereby each pixel may be made to emit light at 100 Cd/$m^2$ when the pixel area ratio and various losses are ignored. On the contrary, in the case of achieving the same display luminance in the passive matrix type drive system, the duty ratio of driving each pixel is 1/100, and each pixel emits light only in the duty period (select period), so that the luminance in the period has to be 10,000 Cd/$m^2$, 100 times as large as the above.

Current applied to the organic EL element can be enhanced to increase the luminance. However, it is known that the light-emitting efficiency of the organic EL element is reduced as the current is enhanced. When the active matrix type drive system and the passive matrix type drive system are compared at the same display luminance, the passive matrix type drive system shows a relatively large power consumption due to the reduction of the efficiency. Further, when the current applied to the organic EL element is enhanced, the materials are likely to be deteriorated by heat generation, etc., so that the lifetime of the display device is shortened disadvantageously. When the maximum current is limited in view of the efficiency and the lifetime, the emission period has to be extended to obtain the same display luminance. However, the duty ratio, which defines the emission period of the passive matrix type drive system, is the reciprocal of the number of rows in the panel, whereby the extension of the emission period limits the display capacity (number of driving lines). In terms of the problems, the active matrix type drive system is demanded to achieve a large-area, high-definition panel.

In the active matrix type drive system suitable for the large area and the high definition, a thin film transistor (TFT) using polysilicon is used as the switching element of each pixel. However, the TFT using polysilicon is formed at high temperature of at least 250°C, whereby it is difficult to use a flexible plastic substrate therefor. Further, the display device using the active matrix type drive system is disadvantageous in high production costs. For example, the production cost of an active matrix substrate is 50% or more of the total cost of the display panel.

To overcome the problems of the conventional organic EL display panels, JP-A-2001-160492 (Patent Document 1) discloses a novel type of organic thin film EL device.

Described in Patent Document 1 are a novel organic thin film EL device and a method for driving the same, and the device has such a memory property that the emission and non-emission states depend on past applied voltage unlike the conventional devices, so that the states can be controlled by applying on/off signals. More specifically, the content of the disclosure is as follows: a current switching layer comprising a thin film of a substance, which is converted from an insulating material to a conductive material by applying a predetermined voltage, is formed between an organic thin film and one or both electrodes; a predetermined voltage is applied to the electrodes to convert the current switching layer from insulating to conductive, thereby turning the organic thin film electroluminescence device into the emission state; then the voltage is reduced to convert the current switching layer from conductive to insulating, thereby turning

the device into the non-emission state; and in a particularly preferred embodiment, the emission and non-emission states are switched by applying a constant voltage to the device continuously and by superimposing positive and negative pulse voltages on the constant voltage.

Further, WO 01/15233 (Patent Document 2) discloses driving control of a pixel by an organic thin film transistor. In this disclosure, a driving device is composed of an organic material, whereby the device can be produced at low temperature and thus a flexible plastic substrate can be used. Additionally inexpensive materials and processes can be used to achieve cost reduction.

In terms of the switching element, *"Formation of Cu:TCNQ Complex Thin Film by Vacuum Deposition and Switching Element", 49th Oyo Butsurigaku Kankei Rengo Koenkai Koen Yokoshu,* March 2002, Tokai University, Shonan Campus, Third issue, 27a-M-5 (Non-Patent Document 1) is known as a technology for driving an organic LED. Further, a switching element comprising aminoimidazole dicarbonate (AIDCN) for binary-driving an organic EL element, and possible application thereof for memory, etc. are shown in a paper L. P. Ma, *"Organic electrical bistable devices and rewritable memory cells", Applied Physics Letters,* Vol. 80, number 16, 22 April 2002, 2002 American Institute of Physics (Non-Patent Document 2). These elements have binary resistance to one voltage, and the switching is caused by applying an appropriate pulse. Though the resistance switching takes only about 10 nsec and has a response sufficient for a common display drive, a specific method of driving a display device with a matrix structure (a dot matrix display) is not disclosed in the documents.

The display device having a matrix structure is generally driven in the following manner. First the case of one pixel is described below. As shown in Fig. 11, the exemplified switching element has two voltage-current characteristics of a high-resistance property 114A (off state) and a low resistance property 114B (on state), and under a bias Vb, an applied voltage of Vth2 or more causes off to on transition and an applied voltage of Vth1 or less causes on to off transition. Thus, the resistance can be switched by applying a pulse of Vth2 or more to cause the off to on transition and by applying a pulse of Vth1 or less to cause the on to off transition.

In a display device 12 shown in Fig. 9 having a display pixel with a stack structure, as shown in Fig. 10, rows are sequentially selected to cause scanning display, and data is written into pixels of a row in the selected period of that row. The case where a plurality of pixels are arranged into a matrix of thus defined columns and rows to perform dot matrix display is described below. In the display device 12 of Fig. 9, a row electrode 104, a light-emitting portion 110, a pixel electrode 112, a switching element 114, and a column electrode 116 are formed on one surface of a glass substrate 120.

In such a plurality of pixels with the matrix structure, by controlling a pixel of a row in the above manner and by maintaining bias within the range of Vth1 to Vth2 until the scan period, the switching element can be maintained in the state of on or off without limitation of the duty period. This control causes the following disadvantage. In the case of using the above switching element shown in Fig. 9, voltage has to be continuously applied to the switching element in the scan period (the frame period), and thus voltage has to be continuously applied to the pixels in the entire matrix, whereby also circuits in the rows other than the selected row have to be in the connected states. Thus, a switching signal for one row is applied to all the rows. As a result, in the case of using the switching element 114 shown in Fig. 9, it is difficult to achieve the on/off control of the pixels in the entire matrix by using the conventional passive matrix type drive system per se.

Patent Document 1: JP-A-2001-160492

Patent Document 2: WO 01/15233

Non-Patent Document 1: Takahito Oyamada, *"Formation of Cu:TCNQ Complex Thin Film by Vacuum Deposition and Switching Element", 49th Oyo Butsurigaku Kankei Rengo Koenkai Koen Yokoshu,* March 2002, Tokai University, Shonan Campus, Third issue, 27a-M-5

Non-Patent Document 2: L. P. Ma, *et al., "Organic electrical bistable devices and rewritable memory cells", Applied Physics Letters,* Vol. 80, Number 16, 22 April 2002, 2002 American Institute of Physics

## Disclosure of the Invention

### Problems that the Invention is to Solve

To solve the above problem, described as a method for driving a matrix-structure display device in a patent application by some of the inventors (Japanese Patent Application No. 2002-255763) is a method for driving a light-emitting panel, comprising duty-driving rows one-by-one and applying a signal for emission control successively to the corresponding columns in the same row to make pixels emit light by current-driving. In the method, to cause emission or non-emission of a particular pixel in response to an emission or quenching signal applied in a predetermined window period, a predetermined voltage is applied to a row to be duty-driven, and an offset voltage of the predetermined voltage is applied to the other rows only in the window period.

According to the method described in Japanese Patent Application No. 2002-255763, there is provided a display

device having a matrix structure. In this method, the emission state of each pixel is on/off binary, and to obtain multitone display, the duty drive frequency has to be increased to change the emission levels in each period, or alternatively the pixel areas have to be different. However, in these methods, the devices are required to have a high response, and the obtained tone level is insufficient because of the influence on image resolution. For example, 8 tones can be controlled by increasing the duty drive frequency from common 60 Hz to 480 Hz. However, 256 tones are required in each of 3 colors to obtain a so-called full color display (16,770,000 colors). It is difficult to obtain more drive frequency than this from the viewpoint of the response of the device, whereby full color display cannot be obtained by increasing the frequency of the passive matrix type device.

The full color display can be obtained using a conventional silicon TFT, etc. However, as described above, preparation of the silicon TFT on a flexible plastic substrate is difficult and costly.

Accordingly, an object of the present invention is to provide a display device such as an organic EL display panel, which can show multiple tones at a low cost and can be formed on a flexible substrate, and a method for driving the same, in view of the above problem.

Further, from the viewpoint that efficiency and lifetime of an organic EL element are reduced as the emission luminance is increased, another object of the invention is to provide a display device, which comprises a thin film light-emitting element comprising a capacitor connected to an organic EL element in parallel and has excellent display properties with sufficient areas of the light-emitting element and the capacitor, and a method for producing the same.

Organic EL elements generally have remarkably high electrical resistance at low voltage, so that discharge of capacitor becomes slow at a certain voltage as shown in Fig. 3. Thus, as shown in Fig. 15, the charge remains in the capacitor even in the next duty period, and affects the light emission in the next frame period. To prevent such influence, the residual charge in the capacitor has to be removed once. The on/off ratio is reduced particularly in a case where light remains in a non-emission frame. As a measure against this problem, for example, JP-A-2001-350431 discloses a method of connecting a capacitor portion and a light-emitting portion to different wirings, and applying a reverse bias voltage to the capacitor portion to eliminate the residual charge in the non-emission state. Further, JP-A-2003-228326 discloses a similar method. These methods can eliminate the previous record. However, the eliminated electric power does not contribute to light emission and is ineffective, to cause the power consumption increase. Further, not every accumulated charge contributes to emission, and this causes a problem of unevenness of light emission. Furthermore, more wirings for the pixels are required to increase the production costs.

Means for Solving the Problems

According to the present invention, there is provided a display device comprising, on a substrate, first stripe electrodes formed in parallel with each other, second stripe electrodes formed in parallel with each other crosswise to the first stripe electrodes, and a plurality of pixels formed at spatial intersections between each of the first stripe electrodes and each of the second stripe electrodes, and each of the pixels comprises a switching element comprising a two-terminal nonlinear element connected electrically to one of the first stripe electrodes, a light-emitting portion connected electrically to the switching element and one of the second stripe electrodes, and a capacitor portion comprising an organic dielectric material as a dielectric layer, connected electrically to the switching element and the one of the second stripe electrodes electrically in parallel with the light-emitting portion.

By using the two-terminal nonlinear element as the switching element in a drive system similar to a passive matrix drive system (or a duty drive system, or a simple matrix drive system), hold type display (display not only in the duty period but also in the off duty period) can be obtained by the switching element. In this display, the capacitor portion acts to accumulate charge for light emission in the off duty period. The hold type display can be achieved in the two-terminal element by using the capacitor portion.

In the invention, an organic dielectric material is used for the dielectric layer, whereby the layer does not have to be formed at high temperature and can respond to deformation of the substrate.

In the invention, a ceramics material may be used for the dielectric layer of the capacitor portion instead of the organic dielectric material. Thus, there is also provided a display device comprising a capacitor portion, which comprises barium strontium titanate oxide as a dielectric layer and connected electrically to the switching element and the one of the second stripe electrodes electrically in parallel with the light-emitting portion.

In the invention, in the case of using an organic dielectric material for the dielectric layer, it is preferred that the dielectric layer further comprises a large number of conductive fine particles dispersed. The switching element is preferably a bistable element or a diode element. In the case of dispersing metal microparticles, the practical relative dielectric constant is 50 to 150 though it depends on deposition conditions. In the invention, in the case of using an organic dielectric material, the relative dielectric constant is preferably 50 or more, more preferably 100 or more.

In the invention, in the case of using barium strontium titanate oxide in the dielectric layer, the relative dielectric constant is approximately 250 to 800. Further, barium strontium titanate oxide has a high resist voltage of about 50 MV/m, at most 150 MV/m. In the invention, in the case of using a ceramics-based material, the relative dielectric constant

of the material is preferably 250 or more. Further, in the invention, the ceramics-based material preferably has a resist voltage of 50 MV/m.

In the invention, the switching element preferably has a stack structure of aluminum/dicyano compound/aluminum, a film stack of a polyethylene dioxythiophene film and a polyphenylenevinylene film, a stack structure of an aluminum thin film/a fullerene thin film/a copper thin film, or a stack structure of an aluminum electrode/a butadiene compound/a gold electrode.

In the invention, the diode preferably comprises C60 or pentacene.

By using the conductive fine particles, the effective dielectric constant of the dielectric layer is increased, and thereby the capacitor portion can have a sufficient capacity in a small area. Thus the area of the light-emitting portion can be increased, whereby the current density in the light-emitting portion can be reduced to improve the light-emitting efficiency and lifetime of the portion. Further, when the bistable element is used in the display device of the invention, the bistable element acts in combination with the capacitor portion to maintain the emission in the off duty period, so that a display with a larger capacity (a larger number of display lines) can be obtained in addition to excellent light-emitting efficiency or lifetime. Also in the case of using the diode element, the capacitor portion can be sufficiently charged when the diode element is in the conducting state, so that a display with a larger capacity can be obtained in addition to excellent light-emitting efficiency or lifetime. Further, in the case of using C60 or pentacene in the diode, the voltage drop is smaller as compared with the case of using the other organic material. Thus, the power loss is prevented, and the diode is remarkably advantageous in the power consumption.

In the invention, it is preferred that the display device comprises the light-emitting portion and the capacitor portion in the same plane, or further comprises an insulation portion for electrically separating the light-emitting portion from the dielectric material layer of the capacitor portion. When the light-emitting portion and the capacitor portion are disposed in the same plane, a display device with a simple structure can be produced.

In the invention, it is also preferred that the substrate is a flexible substrate. The display device can be produced without high-temperature processes, whereby the flexible substrate can be used in the invention. A display device having lighter weight and higher impact resistance can be obtained by using the flexible substrate, as compared with the case of using a glass substrate.

In the invention, it is also preferred that the display device is such that the light-emitting portion, the capacitor portion, and the switching element are thin films formed on the substrate, have electrode layers on both sides, and are stacked on the substrate in this order or the reverse order together with the electrode layers, the capacitor-facing electrode of the light-emitting portion and the capacitor-facing electrode of the switching element are electrically connected by a first via in the capacitor portion, the light-emitting portion-facing electrode of the capacitor portion and the one of the second stripe electrodes are electrically connected by a second via in the light-emitting portion, and the display device further comprises an insulation portion for insulating the light-emitting portion from the capacitor portion.

The via is referred to also as a through hole, and known to those skilled in the art as a measure for electrically connecting layers. In the case of using the stack structure of the light-emitting portion and the capacitor portion, the light-emitting portion and the capacitor portion can have large areas, and thereby are excellent in the efficiency and lifetime, and the capacity.

In the invention, it is preferred that the first via is formed along a side of the capacitor portion through a side surface of the capacitor portion and is lined with an insulating material, the second via is formed along a side of the light-emitting portion through a side surface of the light-emitting portion and is lined with an insulating material, and the insulating materials are continuous with the insulation portion.

In the case of stacking the capacitor portion and the light-emitting portion, the vias for maintaining the electric connection may be disposed through the side surfaces of the capacitor portion and the light-emitting portion to simplify the structure of the vias. The vias may be lined with the insulating material continuous with the insulation portion. Thus, the display device can have a simpler structure.

In the invention, it is preferred that the display device comprises an electrode layer as the first or second stripe electrodes on the substrate, and further comprises a plurality of electrically insulating barriers, which extend crosswise to the stripe electrodes of the electrode layer, divide adjacent pixels in the direction of the stripe electrodes, and have an overhang portion protruding in parallel with the substrate at the top.

In the invention, there is also provided a method for producing a display device. Thus, provided is a method for producing the above described display device, comprising the steps of forming the light-emitting portion having the electrode layers by oblique deposition using the barrier as a mask, forming the insulation portion by oblique deposition using the barrier as a mask, forming the capacitor portion having the electrode layers by oblique deposition using the barrier as a mask, and forming the switching element having the electrode layers by oblique deposition using the barrier as a mask.

By using the overhang portion, the display device can be produced without costly photo processes. Such a display device with excellent display properties can be produced while maximally eliminating mask deposition processes, which is a process for forming a film through a mask.

In another aspect of the invention, there is provided a method for driving the above display device. In the method, the display device is a dot matrix display device using a duty drive system such that each of the pixels is addressed by a respective one of the row electrodes and a respective one of the column electrodes of the combination of the first and second stripe electrodes. The method comprises, in a duty period of a selected row, the first step of applying a signal for converting the switching element to a conducting state by the row electrode, the column electrode, or both thereof, the second step of accumulating a charge for light emission of the light-emitting portion in the capacitor portion through the conducting-state switching element by the row electrode, the column electrode, or both thereof, and the third step of applying a signal for converting the switching element to a non-conducting state by the row electrode, the column electrode, or both thereof. And the method comprises, in an off duty period of the selected row, the step of releasing the charge accumulated in the capacitor portion from the light-emitting portion to emit light therefrom.

In the invention, there is provided the driving method using a dot matrix drive, which uses the pixels for displaying an image, each pixel being addressed by the rows and columns (or X and Y). The signal for converting the two-terminal nonlinear element into the conducting state may be used for the two-terminal nonlinear element having no hysteresis property or for the element having a hysteresis property (e.g. the bistable element), and is generally a high voltage. When the charge is then accumulated, a signal is applied such that a current sufficient for accumulating the charge is provided depending on the properties of the two-terminal nonlinear element.

The charge for making the light-emitting portion emit light is selected in view of achieving a desired emission luminance, and multiple tones can be displayed in accordance with the amount of the charge.

Further, when the switching element is converted to the non-conducting state, the leak current through the switching element is practically negligible. The signal is applied by the row electrodes and the column electrodes to the switching element, and the light-emitting portion and the capacitor portion, which are connected in series with the switching element and connected in parallel with each other. It is preferred that the signal causes the switching action of the switching element appropriately. The signal for converting to the non-conducting state is particularly effective in the case of using the bistable element.

The first and second steps may be carried out in a predetermined first window period and a predetermined second window period, respectively. The first and second window periods are time intervals determined in this order between the duty periods of the selected rows.

In the invention, it is preferred that, in the first step, a voltage offset signal is applied to the row electrodes of rows other than the selected row, the voltage offset signal having a polarity equal to that of a voltage signal applied to the column electrode. Further, it is also preferred that, in the first step, a voltage offset signal is applied to the row electrode of the selected row, the voltage offset signal having a polarity reverse to that of the voltage signal applied to the column electrode. In addition, it is also preferred that, in the third step, a voltage offset signal is applied to the row electrodes of rows other than the selected row, the voltage offset signal having a polarity equal to that of the voltage signal applied to the column electrode. Furthermore, it is also preferred that, in the third step, a voltage offset signal is applied to the row electrodes of rows other than the selected row, the voltage offset signal having a polarity equal to that of the voltage signal applied to the column electrode.

In the first or third step in the duty period of the selected row, when the offset signal having the equal polarity is applied to the row electrodes of the unselected rows (the rows other than the selected row) such that the voltage signal (the voltage pulse, etc.) applied to the column electrode is cancelled, the switching element can be converted into the conducting state or the non-conducting state only in the selected row. Further, when an offset signal having the reverse polarity is applied to the row electrode of the selected row such that the offset signal is added to the voltage signal (the voltage pulse, etc.) applied to the column electrode, the offset voltage is superimposed on the voltage of the column electrode, whereby the switching element can be converted into the conducting state or the non-conducting state only in the selected row in the same manner as above.

To convert the switching element into the conducting state or non-conducting state, considering the properties of the switching element and the voltage share of elements connected therewith in series, a voltage signal of more than the threshold value for converting the switching element into the conducting state or less than the threshold value for converting the switching element into the non-conducting state is applied by the row electrode of the selected row and the column electrode. The offset voltage applied to the row electrodes of the unselected rows is determined such that it is not more (or less) than the threshold value.

In a further aspect of the invention, there is provided a method for driving the above display device. In the method, the display device is a dot matrix display device using a duty drive system such that each of the pixels is addressed by a respective one of the row electrodes and a respective one of the column electrodes of the combination of the first and second stripe electrodes. The method comprises, in a duty period of a selected row, the first step of converting the switching element into the conducting state and accumulating a charge for light emission of the light-emitting portion through the conducting-state switching element in the capacitor portion by the row electrode and the column electrode. The method comprises, in an off duty period of the selected row, the step of releasing the charge accumulated in the capacitor portion from the light-emitting portion to emit light therefrom.

In a still further aspect of the invention, there is provided a method for driving the display device. In the method, the display device is a dot matrix display device using a duty drive system such that each of the pixels is addressed by a respective one of the row electrodes and a respective one of the column electrodes of the combination of the first and second stripe electrodes. The method comprises, in a duty period of a selected row in a frame period, the first step of applying a reverse bias voltage to the switching element, accumulating a charge through the switching element in the capacitor portion, and applying a signal for making the charge releasable by the row electrode, the column electrode, or both thereof, and the second step of applying a forward bias voltage to the switching element to convert the switching element to a conducting state, thereby accumulating a charge for emission of the light-emitting portion in the capacitor portion through the conducting-state switching element by the row electrode, the column electrode, or both thereof. The method comprises, in an off duty period of the selected row in the frame period, the step of releasing the charge accumulated in the capacitor portion from the light-emitting portion to emit light therefrom. Further, in a duty period of the next frame period, the residual charge remaining in the capacitor portion corresponding to the selected row is released by the first step.

In a case where the switching element is a diode element that shows a low resistance at high voltage and shows a high resistance at low voltage, the capacitor can be charged through the diode element when a high voltage is applied to the switching element, and matrix driving can be conducted without leakage of the charge through the diode element when the voltage is lowered.

Further, in the duty period, the charge accumulated in the previous frame can be certainly released by using the reverse bias for releasing the charge in the capacitor.

An example of a method for using a rectifier for pixel emission control in the display device of the invention is described below. The method is for a dot matrix display using such a duty drive system wherein each pixel is addressed by respective stripe electrodes of the column electrodes (data signal lines or Y electrodes) 116 and the row electrodes (timing signal lines or X electrodes) 104 shown in Fig. 6. The method comprises, in a duty period of a selected row, the first step of converting the rectifier into the conducting state by the row electrodes, the column electrodes, or both thereof, to accumulate a charge in the capacitor portion, and the second step of applying a signal for converting the rectifier to the non-conducting state by the row electrode, the column electrode, or both thereof. The method further comprises, in an off duty period of the selected row, the third step of maintaining current in the light-emitting portion by the charge accumulated in the capacitor portion. Further, in the next duty period, the method comprises the fourth step of converting the light-emitting portion to the conducting state by the row electrodes, the column electrodes, or both thereof, to release the charge remaining in the capacitor portion, and the fifth step of applying a signal for converting the light-emitting portion to the non-conducting state by the row electrodes, the column electrodes, or both thereof.

When the charge is accumulated through the rectifier in the capacitor portion, a signal capable of applying current sufficient for accumulating the charge is applied depending on the properties of the rectifier. Further, the charge may be such that the desired emission luminance is obtained, to achieve multiple-tone display depending on the charge amount.

Further, it is preferred that, when converting to the non-conducting state, the signal is such that the leak current is reduced to practically non-conducting state.

The fourth and fifth steps may be carried out in a predetermined first window period 706, and the first and second steps may be carried out in a predetermined second window period 705. The first and second window periods are time intervals determined in this order between the duty periods of the selected rows. In the fourth and fifth steps the previous record is eliminated by releasing the remaining charge, and in the first and second steps the next signal is written, so that it is preferred that the steps are carried out in the above order.

In a case where the rectifier shows a low resistance at high voltage and shows a high resistance at low voltage, the capacitor can be charged through the rectifier when a high voltage is applied to the rectifier, and matrix driving can be conducted without leakage of the charge through the rectifier when the voltage is lowered.

In the invention, there is provided a method for driving a display device comprising a first electrode, a second electrode, a rectifier connected electrically to the first electrode, a light-emitting portion connected electrically to the rectifier and the second electrode, and a capacitor portion connected electrically to the rectifier and the second electrode electrically in parallel with the light-emitting portion. The method comprises, in a duty period, the first step of applying a voltage offset signal (a voltage relative to the ground potential) to one or both of the first and second electrodes to release a charge remaining in the capacitor portion from the light-emitting portion, and the second step of accumulating a charge for emission of the light-emitting portion in the capacitor portion. And the method comprises, in an off duty period, the step of releasing the charge accumulated in the capacitor portion from the light-emitting portion to emit light therefrom.

By releasing the charge remaining in the capacitor, accumulated by the previous drive, in the first step in the duty period, the non-emission display is not affected by the emission in the previous drive effectively.

Further, it is preferred that the method for driving the display device is characterized in that the first electrode is one of first stripe electrodes formed in parallel with each other, the second electrode is one of second stripe electrodes formed in parallel with each other crosswise to the first stripe electrodes, the display device comprises on a substrate

a plurality of pixels formed at overlaps between each of the first stripe electrodes and each of the second stripe electrodes, the rectifier is connected electrically to one of the first stripe electrodes and disposed in each of the pixels, the light-emitting portion is connected electrically to the rectifier and one of the second stripe electrodes and disposed in each of the pixels, the capacitor portion is connected electrically to the rectifier and the one of the second stripe electrodes in parallel with the light-emitting portion, and disposed in each of the pixels, and the display device is a dot matrix display device using a duty drive system such that each of the pixels is addressed by a respective row electrode and a respective column electrode of the combination of the first and second stripe electrodes. Thus, the dot matrix display can be achieved by using a large number of stripe electrodes.

Advantage of the Invention

In the present invention, the switching element, the light-emitting element, and the capacitor may each comprise an organic electronic material thin film with a thickness of about 100 nm and a metal electrode film. Thus, it is easy to reduce the cost of the display device, increasing the area thereof, and use a flexible substrate therein. Further, multiple tone display can be achieved with low cost. There are provided the display device and the production method thereof, and when the display device comprises a thin film light-emitting element comprising a capacitor connected with an organic EL element in parallel, the limitation to the areas of the light-emitting element and the capacitor can be minimized.

Further, in the preferred embodiments using a large number of conductive fine particles dispersed or barium strontium titanate oxide with a high relative dielectric constant in the dielectric layer of the capacitor portion, the capacitor portion has a high dielectric constant and can accumulate a large amount of charge in a small area, and in the case of apposing the light-emitting portion and the capacitor portion physically, the light-emitting portion can have a larger area to reduce the current density, thereby showing a high light-emitting efficiency.

Brief Description of the Drawings

Fig. 1 is an explanatory view showing an example of structure of the display device of the present invention.

Fig. 2 is an explanatory view illustrating an equivalent circuit of a display device using a bistable element as a switching element.

Fig. 3 is an explanatory view showing an example of voltage and emission state of the display device using the bistable element as the switching element.

Fig.4 is an explanatory view showing voltage distribution of an organic EL element and a bistable element connected in series under a voltage.

Fig. 5 is an explanatory view showing an example of a method for applying a voltage to each display device in the duty period and off duty period.

Fig. 6 is an explanatory view showing an equivalent circuit using a rectifier as a switching element.

Fig. 7 is an explanatory view showing an example of voltage and emission state of a display device using the rectifier as the switching element.

Fig. 8 is an explanatory view showing structure of a display device and a method for producing the same according to an embodiment of the invention.

Fig. 9 is a cross-sectional view showing an example of connecting (stacking) a conventional organic EL element and a switching element in series.

Fig. 10 is an explanatory view showing a matrix structure of a display device.

Fig. 11 is a view showing voltage-current characteristic of a switching element under a positive off signal voltage.

Fig. 12 is an explanatory view showing an example of voltage and emission state of the display device using a rectifier as a switching element, other than that of Fig. 7.

Fig. 13 is a view showing an example of voltage-current characteristic of a diode element using C60 as an organic electronic material.

Fig. 14 is a view showing an example of voltage-current characteristic of a diode element using pentacene as an organic electronic material.

Fig. 15 is a view showing time variation of a current applied to an organic EL element according to an embodiment of the invention.

Fig. 16 is a view showing an example of voltage-current characteristic of a diode element using a polyethylene dioxythiophene film and a polyphenylenevinylene film as organic electronic materials.

Fig. 17 is a view showing an example of voltage-current characteristic of the organic EL element of Example 2.

Fig. 18 is a characteristic view showing time variation of the voltage waveform applied to each electrode, the voltage waveform applied to each electrode or element, and emission intensity of an embodiment of the invention.

Fig. 19 is an enlarged characteristic view showing part of the time variation of the voltage waveforms and the emission intensity.

Fig. 20 is an explanatory view showing an example of electric properties of the light-emitting element of the invention.

Fig. 21 is a cross-sectional view showing structure of a pixel of the display device according to an embodiment of the invention.

Description of Reference Numerals and Signs

| | |
|---|---|
| 102, 802 | Plastic substrate |
| 104, 804 | row electrode, Timing signal line, X electrode |
| 116, 834 | column electrode, Data signal line, Y electrode |
| 110 | Light emitting portion |
| 114 | Switching element |
| 106 | Capacitor portion |
| 112 | Pixel electrode |
| 702 | Duty period |
| 704 | Off duty period |

Best Mode for Carrying Out the Invention

Embodiment 1

Summary

Embodiment 1 is described in detail below. In Embodiment 1, in a duty period, a charge corresponding to emission amount is accumulated in a capacitor connected in parallel to a pixel of a row, which is duty-driven, in a matrix. In periods other than the duty period, light is continuously emitted by discharge from the capacitor.

Though conventionally ceramic oxide-based materials have widely been used as dielectric materials for capacitors, the materials are disadvantageous in that they cannot deform in response to a deformation of substrates. In this embodiment, a dielectric material layer is composed of an organic dielectric material comprising conductive fine particles dispersed to overcome the disadvantage of the conventional capacitors. Further, in this embodiment, used as a switching element is a switching element (a bistable element), which is in the conducting state after the applied voltage becomes more than the first threshold value and in the non-conducting state after the applied voltage becomes less than the second threshold value, or a rectifier (a diode element). Current is passed through these elements in the direction vertical to the thin film surface, whereby the elements can be easily stacked with a light-emitting element. And the elements can have a larger current path area, as compared with elements where current is passed in the plane direction, whereby a large current can be easily obtained. Particularly, the electrical resistance of the bistable element can be

changed within the range of several figures by applying a pulse electric field, whereby the bistable element is a preferred switching element because it can be controlled and matched to the light-emitting element easily, have a large current effective area to obtain a large current, and have a large transition rate.

Through the switching element, in the duty period, the charge is accumulated in the capacitor connected in parallel with each light-emitting portion in each row. In the off duty period, each pixel is electrically isolated from its respective signal line (e.g. column electrode) by the switching element, and light is continuously emitted by the charge accumulated in the capacitor. The amount of the charge accumulated can be controlled depending on the desired emission intensity, so that multiple tones can be easily displayed.

In the invention, a ceramic oxide-based material is preferably used in the capacitor. For example, an excellent capacitor can be obtained by forming a typical ferroelectric material of barium strontium titanate into a several hundred nanometer-thick film using an RF magnetron sputtering method, and by heat-treating the film at approximately 650°C. As described in e.g. JP-A-2002-280380, it is known that a high dielectric constant, e.g. a relative dielectric constant of more than 40, can be obtained even in the case of forming barium strontium titanate into a film at low temperature by plasma anneal.

Details

Fig. 1 is a cross-sectional view showing the cross section structure of a pixel of a display device 10 according to this embodiment. A row electrode 104 comprising ITO (indium tin oxide) of a transparent electrode material is formed on one surface of a plastic substrate 102. The row electrode 104 may be referred to as a timing signal line, an X electrode, etc. (e.g. Fig. 2). The row electrode 104 is patterned into striped electrodes in parallel with each other. In this figure, one pixel is magnified and the entire patterned electrode is not shown. A light-emitting portion 110 comprising an organic EL element and a capacitor portion 106 are apposed on the row electrode 104, and separated by a barrier 108. Further, a pixel electrode 112 comprising a metal such as aluminum, a switching element 114, and a column electrode 116 comprising a metal are formed thereon, and the column electrode 116 is patterned into striped electrodes disposed in parallel with each other crosswise to the row electrode 104. The column electrode 116 may be referred to as a data signal line, a Y electrode, etc. (e.g. Fig. 2). Each of the electrodes, the organic EL element, the switching element, the capacitor portion, etc. comprises a thin film, and current is passed through the organic EL element or the switching element in the direction vertical to the film surface.

The case of using a bistable element 202 as the switching element 114 is described below. Fig. 2 is an equivalent circuit diagram of a pixel of the display device 10 in this case, and Fig. 3 is a schematic view showing the waveform of a voltage applied to the column electrode (the data signal line or Y electrode) 116 in a pixel (Fig. 3a), the waveform of a voltage applied to the row electrode (the timing signal line or X electrode) 104 (Fig. 3b), and the waveform of a voltage applied to the light-emitting portion 110 and the switching element 114 (Fig. 3c), calculated therefrom. The emission state 314 of the light-emitting portion 110 is also shown in Fig. 3c.

In the duty period 302 (selected period) of a pixel in a row, a part of the difference between a voltage for an on signal 306 of the column electrode 116 and a voltage of the row electrode 104, is applied to the bistable element 202 in the pixel and converts the element into the conducting state. Then, a current from the column electrode (the data signal line) 116, which acts as a charging voltage 310, is applied to and accumulated in the capacitor portion 106. Immediately before the period next to the duty period 302 (the off duty period 304), a part of the difference between a voltage for an off signal 308 of the column electrode 116 and an offset voltage 312 for signal cancellation of the row electrode 104, is applied to the bistable element 202 and converts the element into the non-conducting state, so that the pixel electrode 112 is isolated from the column electrode 116. After the isolation, the capacitor 106 is discharged to maintain the emission state 314.

Fig. 4 shows the relation between the partial voltage divided between the light-emitting portion 110 and the bistable element 202 in the duty period 302 and the off duty period 304. A capacitor 402a shown in Fig. 4 is the equivalent circuit of the bistable element 202 in the non-conducting state (the off state), and a resistance 402b is the equivalent circuit of the bistable element 202 in the conducting state (the on state). The potential difference between the row electrode and the column electrode is applied entirely to the bistable element 202 in the non-conducting state, while only the fraction $\alpha$ ($0 < \alpha < 1$) of the potential difference is applied to the bistable element 202 in the conducting state. The behavior of the bistable element 202 is basically equal to that shown in Fig. 11 of the operating characteristic view of the conventional bistable element.

Fig. 5 is described in detail below. Fig. 5a shows the voltage waveform of a selected row in the duty period of the selected row, and Fig. 5b shows the voltage waveform of an unselected row in the same period as Fig. 5a. A pixel in the selected row and another pixel in the unselected row in the same column are compared with respect to the waveforms. The column electrode 116 is common to the pixels, and a the voltage waveform 516 is applied thereto.

In the selected row, no bias voltage is applied to the voltage waveform 508 of the timing signal line 104. On the contrary, in the unselected row, offset voltages Vc and -Vd corresponding to an on signal 502 and an off signal 506

are applied to the voltage waveform 510 of the timing signal line 104. A voltage of $\alpha$ times the voltage waveform 516 is applied to the bistable element 202 in the selected row, while a voltage obtained by subtracting the voltage waveform Vc from Vd (in the period of the on signal 502) and a voltage obtained by adding Vc to Vd (in the period of the off signal 506) are applied in the unselected row. The offset voltage applied in the unselected row is to remove the influence of the signal for switching conducting and non-conducting from the data signal line 116 on the unselected row. Unlike the method, the conducting and non-conducting may be switched by applying an appropriate bias to the timing signal line in the duty period, no bias being applied in the off duty period.

The relation of these voltages is described below. The bias voltage Vb is applied to the switching element, a signal (Von) for switching off to on is applied to generate a current at the beginning of the duty period, and the on state is maintained during the duty period. The current is removed by a signal (-Voff) for switching to off at the end of the duty period. Von and Voff are determined such that switching threshold values Vth1 and Vth2 satisfy the relations of Vb + Von > Vth2 and Vb - Voff < Vth1. As shown in Fig. 5, the switching is prevented by offsetting the bias in each window by -Vc, Vd in rows other than the selected row. In this method, excellent operation can be obtained by determining the voltage such that the following relational expressions are satisfied by the properties of the bistable element, particularly the threshold value voltages.

$$\alpha(Vb - Voff) < Vth1 < \alpha Vb \quad \text{(Expression 1)}$$

$$Vth1 < (Vb - Vc) < Vth2 \quad \text{(Expression 2)}$$

$$Vth1 < (Von + Vb - Vc) < Vth2 \quad \text{(Expression 3)}$$

$$Vth1 < (Vb + Vd) < Vth2 \quad \text{(Expression 4)}$$

$$Vth1 < (Vb + Vd - Voff) < Vth2 \quad \text{(Expression 5)}$$

Fig. 6 shows an equivalent circuit using a rectifier 602 as the switching element, and Fig. 7 is a schematic view showing the waveform of a voltage applied to the column electrode (the data signal line or Y electrode) 116 in a pixel (Fig. 7a), the waveform of a voltage applied to the row electrode (the timing signal line or X electrode) 104 (Fig. 7b), and the waveform of a voltage applied to the light-emitting portion 110 and the switching element 114 (Fig. 7c), calculated therefrom. The emission state 710 of the light-emitting portion 110 is also shown in Fig. 7c. Fig. 7 is an explanatory view showing an example of the voltage and the emission state. The rectifier has such nonlinearity that the resistance is lowered within the range of high voltage. In a duty period 702, a negative bias -Vb is applied to the timing signal line (the row electrode) 104, to reduce the resistance of the rectifier, thereby obtaining the conducting state. When Von is applied to the data signal line, the voltage applied to the rectifier is Von + Vb. In the off duty period 704, no bias is applied and the device is driven at a low voltage, whereby the device is substantially in the non-conducting state.

Further, in Fig. 7, when the light-emitting portion is controlled to the emission state in a frame period, a charge remains in the capacitor even at the end of the frame and may affect the state of the light-emitting portion (the emission state or non-emission state) in the next frame period. Particularly in a case where the next frame is in the non-emission state, the record of the previous emission state has to be eliminated by an appropriate quenching signal. Thus, in this embodiment, as shown in e.g. Fig. 12, the duty period of each row is divided into two, a light-emitting signal voltage VLon is applied to each column electrode in one period, and a non-emission (quenching) signal voltage -VLoff is applied to each column electrode in the other period, and voltages VAon and -VAoff are applied to each row electrode in each period of the selected period (the duty period). In this embodiment, the light-emitting signal voltage is applied in the latter part of the duty period, and the quenching voltage signal is applied in the former part of the duty period. Further, the voltage applied to each row electrode is a bias voltage with a polarity reverse to those of the light-emitting signal and the non-emission signal. By using such voltage waveforms for the row electrodes and the column electrodes, the light-emitting portion 110 emits light in the latter part of the duty period, the light emission is maintained by the capacitor in the off duty period, and the light emission of the light-emitting portion 110 is stopped in the former part of the next frame duty period as emission intensity change 150. As illustrated in Fig. 13, the reverse bias current of a diode element 602 using C60 as the organic electronic material is increased with the reverse bias voltage, so that the charge remaining in the capacitor 106 can be released by applying a sufficient reverse bias voltage. Though the start of the frame period

corresponds to that of the duty period in Fig. 13, generally the periods do not always have the same start timings.

Example 1

An insulating barrier was formed on a polyethylene terephthalate substrate having an ITO layer by a photo process, a light-emitting element was formed on one of the two divided portions, and a capacitor was formed on the other portion. These had the same areas. Further, a switching element is formed to cover these two elements. ITO was patterned into 15-column stripe electrodes with a pitch of 1.0 mm and a width of 0.7 mm beforehand.

A polyethylene dioxythiophene film and a polyphenylenevinylene film were successively formed by an ink jet method, and then a calcium film was formed by vacuum deposition to provide an organic EL layer as the light-emitting element. The thicknesses of the films were 100 nm, 100 nm, and 100 nm, respectively.

Then, the capacitor was formed by a vacuum deposition method such that an organic insulating material of an aminoimidazole dicyanate (Compound 1) and conductive fine particles of aluminum were co-deposited into a dielectric material layer, and electrode layers of aluminum were successively formed. The electrode layer, the dielectric material layer, and the electrode layer had thicknesses of 130 nm, 40 nm, and 130 nm, respectively. The deposition steps were carried out by a diffusion pump exhaust apparatus at a vacuum degree of 4 x $10^{-4}$ Pa (3 x $10^{-6}$ torr). Aluminum was deposited by a resistance heating method at a film forming speed of 30 nm/sec, and aminoimidazole dicyanate layer containing the conductive fine particles of aluminum was formed by a co-deposition method. The deposition was carried out by a resistance heating method, aminoimidazole dicyanate was deposited at a film forming speed of 20 nm/sec, and aluminum was deposited at 10 nm/sec. The layers were successively deposited in one deposition apparatus under the condition that the sample was not in contact with air.

Then, aluminum, the dicyano compound (Compound 1), and aluminum were successively formed by vacuum deposition into a film having a thickness of 100 nm, 30 nm, and 100 nm respectively and covered the two elements, whereby a switching element was formed in series with the organic EL and the capacitor. In the layer structure, the switching element had a bistable characteristic to be hereinafter described. The endmost electrode of the switching element was patterned into 10-row stripe electrodes with a pitch of 1 mm and a width of 0.7 mm perpendicular to the ITO electrode. Thus, a 15-column and 10-row matrix was formed to produce a display device of Example 1.
(Compound 1)

[Chemical Formula 1]

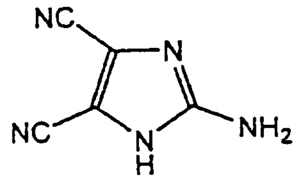

The performance of the switching element was such that, at Vth1 of 0.0 V, Vth2 of 5.0 V, and a bias of 4.0 V, the current density was 40 mA/$cm^2$ in the on state and 0.1 mA/$cm^2$ in the off state. The organic EL element had a voltage drop of 3.5 V and an emission intensity of 30 Cd/$m^2$ in the on state, and did not show voltage drop and light emission in the off state.

When the scan frequency in the entire panel is 240 Hz, thus the scan period is about 4.2 msec, the duty period of each row is 0.42 msec. The panel was steadily driven by controlling a window duration for on/off switching of the switching element (the bistable element) to 0.01 msec and by controlling a pulse width of the switching signal to 0.005 msec under conditions of Vb = 4.0 V, Von = 1.5 V, Voff1 = 4.0 V, Voff2 = 5.5 V, Vc = 1.5 V, and Vd = 0.8 V. In this case, the maximum amount of charge accumulated in the capacitor was approximately 12 $\mu$Q/$cm^2$, and the maximum current density of the bistable element was approximately 40 mA/$cm^2$. The effective area of the switching element was about twice as large as those of the capacitor and the light-emitting element, whereby the device could be driven at the maximum current density lowered for the area. The panel had an average luminance of 25 Cd/$m^2$. Further, the total charge amount in the duty period could be controlled easily by changing the current time to obtain emission luminance tones.

Example 2

An example of dispersing conductive fine particles in a capacitor to increase the dielectric constant is described below. A sample was produced and tested in the same manner as Example 1 except that the conductive fine particles were composed of gold and the electrode layer, the dielectric material layer, and the electrode layer had a thickness of

110 nm, 80 nm, and 110 nm respectively. The panel was steadily driven under the same conditions, the maximum amount of the charge accumulated in the capacitor was approximately 15 μQ/cm$^2$, and the maximum current density of the bistable element was approximately 40 mA/cm$^2$. Further, thus the panel had an average luminance of 30 Cd/m$^2$. The emission luminance tones were easily obtained like Example 1.

Example 3

An insulating barrier was formed on a polyethylene terephthalate substrate having ITO by a photo process, and a polyethylene dioxythiophene film and a polyphenylenevinylene film were formed successively by an ink jet method and a calcium film was formed by vacuum deposition to obtain a rectifier. The films had a thickness of 200 nm, 40 nm, and 120 nm respectively. Then, films of copper phthalocyanine (CuPC)/naphthylphenyldiamine (NPB)/aluminum quinoline (Alq3)/a calcium electrode were formed as an organic EL layer by vacuum deposition successively on one half region of the barrier. The films had a thickness of 100 nm, 50 nm, 50 nm, and 100 nm respectively. A capacitor portion was formed on the other half region in the same manner as Example 1. The deposition of the organic EL portion and the capacitor portion was located by using a metal mask. After the deposition of the organic EL portion and the capacitor portion, an aluminum film covering both the elements was deposited as a common electrode. The aluminum film was patterned into 10-row stripe electrodes with a pitch of 1 mm and a width of 0.7 mm perpendicular to the ITO electrode. Thus a 15-column and 10-row matrix was formed.

Forward voltage-current characteristics of the rectifier and the organic EL element are shown in Figs. 16 and 17. As a result of measuring the voltage drop, for example the voltage drop for controlling the current density at 40 mA/cm$^2$ was approximately 3.5 V in the rectifier and 6.2 V in the organic EL element. Thus, in this example, the capacitor could be charged at 6.2 V by applying the total voltage of 9.7 V. Further, the maximum amount of the accumulated charge was approximately 19 μQ/cm$^2$ in this case. In this example, the panel had an average luminance of 50 Cd/m$^2$. The charge amount in the duty period could be controlled easily by changing the current time or the voltage value to obtain emission luminance tones.

Example 4

A sample was produced in the same manner as Example 3 except that the conductive fine particles for the capacitor were composed of gold and the electrode layer, the dielectric material layer, and the electrode layer had a thickness of 110 nm, 80 nm, and 110 nm respectively, and tested in the same manner as Example 3 except that the applied voltage was 15 V. The panel was steadily driven under the same conditions, the maximum amount of the charge accumulated in the capacitor was approximately 30 μQ/cm$^2$, and the maximum current density of the bistable element was approximately 60 mA/cm$^2$. Further, thus the panel had an average luminance of 50 Cd/m$^2$. The emission luminance tones were easily obtained like Example 3.

Example 5

An insulating barrier was formed on a polyethylene terephthalate substrate having ITO by a photo process, and films of copper phthalocyanine (CuPC)/naphthylphenyldiamine (NPB)/aluminum quinoline (Alq3)/a calcium electrode were formed as an organic EL layer by vacuum deposition successively on one half region of each pixel divided by the barrier. The films had a thickness of 100 nm, 50 nm, 50 nm, and 100 nm respectively. Then, a capacitor portion was formed on the other half region divided by the barrier in the same manner as Example 1. The deposition of the organic EL portion and the capacitor portion was located by using a metal mask. After the deposition of the EL portion and the capacitor portion, an aluminum film covering both the elements was deposited as a rectifier, and fullerene (C60) and copper were successively deposited thereon. The films had a thickness of 100 nm, 100 nm, and 100 nm respectively. The endmost copper film was patterned into 10 rows with a pitch of 1 mm and a width of 0.7 mm perpendicular to the ITO electrode. Thus a 15-column and 10-row pixel matrix was formed.

As a result of measuring voltage drop of the rectifier and the organic EL element, for example the voltage drop for controlling the current density at 40 mA/cm$^2$ was approximately 0.5 V in the rectifier and 6.2 V in the organic EL element. Thus, in this example, the capacitor could be charged at 6.2 V by applying the total voltage of 6.7 V. Further, the maximum amount of the accumulated charge was approximately 19 μQ/cm$^2$ in this case. The panel had an average luminance of 50 Cd/m$^2$. The charge amount in the duty period could be controlled easily by changing the charging time or the voltage value to obtain emission luminance tones.

Example 6

A sample of Example 6 was obtained in the same manner as Example 5 except that the ITO electrode and the

copper electrode had 100-column and 100-row structures with a pitch of 0.5 mm and a width of 0.3 mm. As a result, the sample had electrical characteristics and light-emitting properties equal to those of Example 5. Thus obtained sample was driven under conditions of a voltage of 8 V and a frame frequency of 120 Hz.

As a result of measuring voltage drop of the driven sample, the rectifier showed the voltage drop of approximately 0.7 V while the organic EL element showed the voltage drop of 7.3 V. Thus, in this example, the capacitor could be charged at 7.3 V by applying the total voltage of 8 V. Further, the maximum amount of the accumulated charge was approximately 21 $\mu Q/cm^2$ in this case. In this example, the panel had an average luminance of 70 $Cd/m^2$. Fig. 15 shows time variation of a current passed through the organic EL element in this case.

Example 7

An insulating barrier was formed on a polyethylene terephthalate substrate having ITO by a photo process, and films of copper phthalocyanine (CuPC)/naphthylphenyldiamine (NPB)/aluminum quinoline (Alq3)/an aluminum electrode were formed as an organic EL layer by vacuum deposition successively on one half region of each pixel divided by the barrier. The films had a thickness of 100 nm, 50 nm, 50 nm, and 100 nm respectively. Then, a capacitor portion was formed on the other half region divided by the barrier in the same manner as Example 1. The deposition of the organic EL portion and the capacitor portion was located by using a metal mask. After the deposition of the EL portion and the capacitor portion, a gold film covering the organic EL portion and the capacitor portion was deposited as a rectifier of island-like electrodes per each pixel by using a mask. A pentacene film and an aluminum film were successively deposited thereon. The films had a thickness of 100 nm, 100 nm, and 100 nm respectively. The endmost aluminum film was patterned into 10 rows with a pitch of 1 mm and a width of 0.7 mm perpendicular to the ITO electrode. Thus a 15-column and 10-row pixel matrix was formed.

As a result of measuring forward voltage drop of the rectifier and the organic EL element, for example the voltage drop for controlling the current density at 40 $mA/cm^2$ was approximately 2.0 V in the rectifier and 6.2 V in the organic EL element. Thus, in this example, the capacitor could be charged at 6.2 V by applying the total voltage of 8.2 V. Further, the maximum amount of the accumulated charge was approximately 19 $\mu Q/cm^2$ in this case. The panel had an average luminance of 54 $Cd/m^2$. The charge amount in the duty period could be controlled easily by changing the charging time or the voltage value to obtain emission luminance tones. The reason why the higher average luminance was obtained as compared with Example 5 seems that the rectifier used in this example had the electrical characteristic (Fig. 14) with a smaller leak current under a reverse bias to increase the current efficiency of the organic EL element as compared with the electrical characteristic (Fig. 13) of the rectifier of Example 5.

Example 8

A 100-nm-thick ITO film was formed on a glass substrate by an RF magnetron sputtering method, and 15-column stripe electrodes with a pitch of 1.0 mm and a width of 0.7 mm were formed by a common photolithograph method. A 50-nm-thick platinum film with a pitch of 1.0 mm and a width of 0.3 mm was formed on the ITO electrode, to form an island-like substrate electrode on the ITO electrode, on which barium strontium titanate oxide is disposed. Further, a 100-nm-thick barium strontium titanate oxide film was formed on the platinum film by an RF magnetron sputtering method and a common photolithograph method, and the resultant was heat-treated for 1 hour in an oxygen atmosphere to obtain a capacitor. A barrier in contact with the capacitor was formed to provide a light-emitting element in the same manner as Example 5. Then, a sample of Example 8 was obtained in the same manner as Example 5.

When a forward voltage was applied to the rectifier and the organic EL element, for example the voltage drop for controlling the current density at 40 $mA/cm^2$ was approximately 0.5 V in the rectifier and 6.2 V in the organic EL element. Thus, in this example, the capacitor could be charged at 6.2 V by applying the total voltage of 6.7 V, and the maximum amount of the accumulated charge was approximately 40 $\mu Q/cm^2$. The panel had an average luminance of 100 $Cd/m^2$. The charge amount in the duty period could be controlled easily by changing the charging time or the voltage value to obtain emission luminance tones.

Example 9

A sample of Example 6 was produced in the same manner as Example 5 except for changing the matrix of the ITO electrode and the copper film to a 50-column and 50-row matrix. The waveform of driving voltage is shown in Fig. 12. The frame frequency was 600 Hz (frame period: approximately 1.7 ms). The duty period of each row was 1.7/50 ms, 35 $\mu s$. When VLon and VAon were 3.35 V, a charge of approximately 19 $\mu Q/cm^2$ was accumulated in the capacitor in the latter part of the duty period like Example 5. The charge accumulated in the capacitor was released from the light-emitting portion 110 of the organic EL element in the off duty period. The rest potential (the potential difference between the light-emitting portion 110 and the capacitor 106) was approximately 2.8 V after 1.7 ms of the frame period, though

the organic EL light-emitting portion 110 had nonlinear voltage-current characteristics, so that the discharge properties cannot be represented by a simple expression. A quenching signal for turning VLoff and VAoff to 4 V was applied in the former part of the duty period of the next frame. In this case, the potential difference between the light-emitting portion 110 and the capacitor 106 was increased by VLoff, and the potential of the Y electrode based on that of the X electrode (the timing signal line), in other words the reverse bias voltage applied to the diode 602, was approximately 10 V. As shown in Fig. 13, a current density of 100 $mA/cm^2$ or more was obtained at a reverse bias of 8 V, and thus the charge remaining in the capacitor 106 was released through the diode 602. It was confirmed that, by repeating such application, the emission state in each frame could be excellently controlled such that each pixel was appropriately made to emit light or quenched at an appropriate timing.

Particularly in the case of using C60 or pentacene as an organic material for the rectifier, the voltage drop is lower under a voltage application as compared with the other organic materials. Thus, the power loss in the rectifier can be prevented, whereby the organic materials are remarkably advantageous in power consumption. This is a result from the charge transfer of these materials, higher than those of the other materials.

Embodiment 2

Summary

In above Embodiment 1, the capacitor comprising the organic dielectric material is connected in parallel with the organic EL element, the switching element is connected in series therewith, and thus all the elements are composed of the organic thin films. In Embodiment 1, the limited pixel area is shared by the light-emitting portion and the capacitor connected in parallel therewith. Specifically, the region of the light-emitting portion 110 and the region of the capacitor portion 106 are arranged in a planar in the display device of Embodiment 1 having the structure of Fig. 1. Thus, there is often a limitation that they cannot have large areas. Embodiment 2, which removes the area limitation to reduce a current load applied to the light-emitting element and to increase the area of the capacitor, is described below.

In this embodiment, the component of the display device, the light-emitting element (the light-emitting portion), the capacitor portion, and the switching element are formed on the substrate such that they have areas near the pixel area, and the elements are connected by wirings using a side surface of the elements, whereby the light-emitting portion and the capacitor portion have larger areas as compared with Embodiment 1 and the performance of the device is improved. The wirings are connected through a via covered with an insulating material in the side surface such that a failure such as short circuit is hardly caused. Such a display device can be obtained by using a barrier having an overhang portion and by using the barrier as a mask in an oblique deposition method.

Details

Specifically, in Embodiment 2, the display device has a structure shown in Fig. 8h, and the light-emitting portion 110 and the capacitor portion 106 are stacked with the electric connection relation equal to the circuit shown in Fig. 1. Thus, a larger emission area and a larger capacitor area can be achieved. Like in Embodiment 1, the elements are formed as thin films and a current is passed through the elements in the perpendicular direction to the film. A method for producing the display device having the structure is described below.

First, as shown in Fig. 8a, an electrode film 804 comprising a transparent conductive material, having a thickness of 0.2 μm, etc., is formed on a surface of a plastic substrate 802. In the case of forming a plurality of pixels into a matrix structure in the display device, the electrode film 804 is further patterned by a photolithography method and etching to form stripe electrodes having a pitch of 0.3 mm and a width of 0.28 mm, etc. In Fig. 8, the stripe electrodes extend in the horizontal direction of the drawing.

Then, as shown in Fig. 8b, barriers 806 are formed. For example, in this step, a non-photosensitive polyimide is spin-coated to form a 4-μm-thick base 808 of each barrier on the transparent electrode, and $SiO_2$ is sputtered to form a 0.5-μm-thick overhang portion 810 on the polyimide film. The $SiO_2$ film and the polyimide film are patterned by a photo process, to form each barrier 806 having the overhang portion 810. The barrier 810 having such a T-shaped cross section can be formed by the steps of a reactive ion etching (an anisotropic etching) using a gas of $O_2$, etc., dry-etching the polyimide film 70 perpendicularly without undercut (an arrow 812), and isotropically wet-etching the side surface 816 of the polyimide film for 30 seconds using an alkaline solution (an arrow 814).

Then, as shown in Fig. 8c, e.g. a thin film organic EL element is deposited as the light-emitting portion 110 from an oblique direction making a constant angle θ against the normal direction of the plastic substrate 802. In the oblique deposition, the light-emitting element is not formed and the electrode on the plastic substrate is exposed in a portion interrupted by the barriers 806. The light-emitting portion 110 has an EL light-emitting layer 818 comprising an electron transporting layer, a recombination layer, and a hole transporting layer, and a metal electrode layer 820.

Then, as shown in Fig. 8d, an organic insulating film 822 is deposited from the vertical direction to the plastic substrate 802. In this step, the insulating film 822 is not deposited on a portion along the barriers, which is under the shade of the overhang portions 810.

Next, as shown in Fig. 8e, the capacitor portion 106 is deposited from an oblique angle reverse to that of Fig. 8c. One electrode of the capacitor is formed as a metal electrode 824, which is connected to the electrode film 804 on the plastic substrate through a via 830 (Fig. 8d) lined with the insulating film 822. Then a dielectric material layer 826

for forming the capacitor is formed, and further a metal electrode 828 is formed. In a case where the electrode film 804 of the transparent electrode material is composed of a plurality of parallel stripe row electrodes extending in the horizontal direction on paper of Fig. 8 and divided by patterning in the direction perpendicular to the paper, also the metal electrode 824 and the metal electrode 828 have to be divided into island shape in the direction perpendicular to the paper in accordance with the electrode film 804. Therefore, in the case of the electrode film 804 having the stripe shape, in the step of Fig. 8e, the metal electrode 824 and the metal electrode 828 are deposited using a metal mask (not shown) having an appropriate opening such that they are patterned in accordance with the transparent electrode.

As shown in Fig. 8e, the capacitor portion 106 and the light-emitting portion 110 are isolated by an organic insulating film 822. The total thickness of the layers of from the EL light-emitting layer 818 formed in Fig. 8d to the metal electrode 828 is approximately 300 nm and sufficiently smaller than the width (approximately 2 μm) of a via 830 (Fig. 8d) in the horizontal direction, in which the electrode film 804 of the transparent electrode material exposes. Thus, the masking function of the layers may be mostly ignored, and the layers have no influence on the formation of the metal electrode 824 in Fig. 8e.

Then, as shown in Fig. 8f, an organic insulating film 822a is deposited perpendicular to the glass substrate in the same manner as Fig. 8d such that the film 822a is continuous with the film 822. A via 832 for connection to the metal electrode 820 of the light-emitting portion 110 is lined with an insulating film 822a. As shown in Fig. 8g, a metal electrode 828a is then deposited on the surfaces of both the barriers to connect to the metal electrode 822 through the via 832. Like the case of the metal electrode 828, the metal electrode 828a is patterned by using a deposition mask when the electrode film 804 is stripe. The metal electrodes 828 and 828a act as the pixel electrode 112 shown in Fig. 1. Further, as shown in Fig. 8h, the switching element 114 and an electrode layer 834 are deposited between the surfaces of the barriers.

A display device 80 can be produced by the above steps, and wherein the thin film light-emitting element and the thin film capacitor are connected in parallel with each other, the thin film switching element is connected in series therewith, and the light-emitting portion and the capacitor portion have enlarged areas.

Example 10

A 0.2-μm-thick ITO electrode was formed on a polyethylene terephthalate substrate, and patterned by a photo process into 15 columns with a pitch of 1.0 mm and a width of 0.7 mm. Then a negative photoresist LAX-1 available from Zeon Corporation was applied thereto by spin coating into a thickness of 4 μm, and a 0.5-μm-thick $SiO_2$ film was formed by sputtering. They were etched in the same manner as above, to obtain 10-row barriers with a pitch of 1.0 mm in the direction perpendicular to the ITO electrode. The barriers had a width of 300 μm, a height of 4.5 μm, and an overhang of 2 μm.

Films of Li/aluminum quinoline (Alq3) (Compound 2)/naphthylphenyldiamine (NPB) (Compound 2)/copper phthalocyanine (CuPC) were successively formed as a light-emitting element by vacuum deposition from the direction shown in Fig. 8c. The films had thicknesses of 5 nm, 50 nm, 50 nm, and 100 nm, respectively. In the deposition steps, the deposition sources were placed at a distance of 200 mm from the substrate in the vertical direction and at a distance of 100 mm from the center of the substrate to the left of paper, and a crucible having an opening diameter of 5 mm was used. Then, perfluorotetracosane (n-$C_{24}F_{50}$) was deposited to a thickness of 100 nm as an insulating layer from the direction shown in Fig. 8d.
(Compound 2)

[Chemical Formula 2]

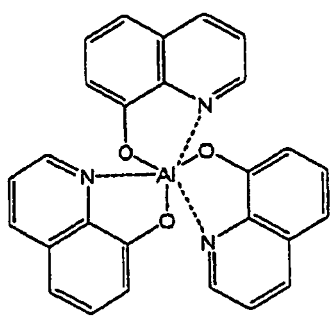

(Compound 3)

[Chemical Formula 3]

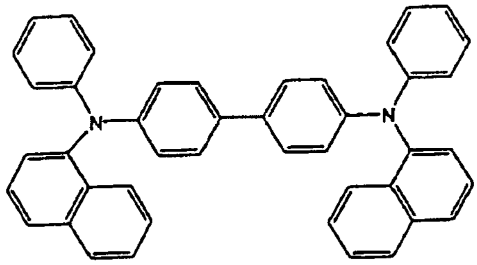

Then, a capacitor element was formed by oblique-depositing an electrode of aluminum, by oblique-co-depositing a dielectric material layer of aminoimidazole dicyanate and conductive fine particles of aluminum, and by oblique-depositing an electrode layer of aluminum successively, from the direction shown in Fig. 8e. In the deposition of aluminum before and after the deposition of the dielectric material layer, a metal mask was used for preventing aluminum from being deposited on a portion of a space between the pattern of the ITO electrode. The films had thicknesses of 100 nm, 40 nm, and 100 nm, respectively. In the deposition steps, the deposition sources were placed at a distance of 200 mm from the substrate in the vertical direction and at a distance of 100 mm from the center of the substrate to the right of paper, and a crucible having an opening diameter of 5 mm was used.

Then, perfluorotetracosane (n-$C_{24}F_{50}$) was deposited to a thickness of 100 nm as an insulating layer from the direction shown in Fig. 8f.

Films of an aluminum electrode/a butadiene compound (Compound 4)/a gold electrode were formed as a diode element into thicknesses of 100 nm, 80 nm, and 100 nm from the direction shown in Figs. 8g and 8h.

(Compound 4)

[Chemical Formula 4]

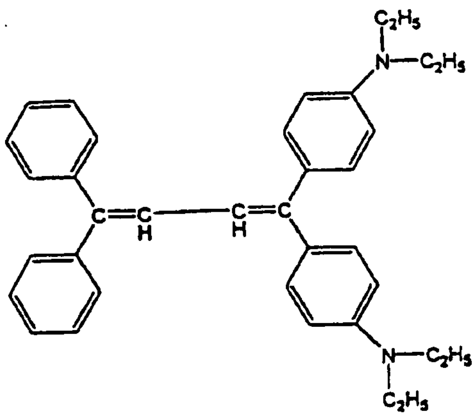

The above vacuum deposition steps were carried out by using a diffusion pump exhaust deposition apparatus at a vacuum degree of 4 x $10^{-4}$ Pa (3 x $10^{-6}$ torr). Aluminum was deposited by a resistance heating method at a film forming speed of 30 nm/sec, and aminoimidazole dicyanate layer containing the conductive fine particles of aluminum was formed by a co-deposition method. The deposition was carried out by a resistance heating method, aminoimidazole dicyanate was deposited at a film forming speed of 20 nm/sec, and aluminum was deposited at 10 nm/sec. The layers were successively deposited in one deposition apparatus under the condition that the sample was not in contact with air.

The conditions for obtaining an average luminance of 25 Cd/$m^2$ in the panel having the above structure are as follows. When the scan frequency in the entire panel is 240 Hz, thus the scan period is about 4.2 msec, the duty period of each row is 0.42 msec. The area of the light-emitting element occupies approximately 49% of 1 pixel, whereby light emission at approximately 50 Cd/$m^2$ was required. Because the light-emitting element had an efficiency of approximately 2.5 Cd/A, a charge of 50 / 2.5 x 4.2 x $10^{-3}$ = 0.084 Q/$m^2$ = 8.4 $\mu$Q/$cm^2$ or more had to be accumulated in the capacitor to maintain the light emission over the scan period of 4.2 msec. To inject the charge into the capacitor during the duty period of 0.42 msec, 20 mA/$cm^2$ or more of current has to be passed through the switching element. A current was

passed through the light-emitting element also in the duty period practically, whereby these currents were superimposed on each other in the switching element to show the maximum current of approximately 22 mA/$cm^2$.

This was compared with the conventional structure of Fig. 1. In the structure of Fig. 1, the area of the light-emitting element is half the area of this example, so that the luminance of the light-emitting surface had to be 100 Cd/$m^2$, and the amount of the charge to be accumulated in the capacitor had to be approximately 17 $\mu$Q/$cm^2$, twice the value of this example. The maximum current density of the switching element in the duty period was approximately 22 mA/$cm^2$, which was not largely different from the value of Example 1.

Example 11

A 0.2-$\mu$m-thick aluminum electrode was formed on a polyethylene terephthalate substrate, and patterned by a photo process into 15-column stripe electrodes with a pitch of 1.0 mm and a width of 0.7 mm. Then a 4-$\mu$m-thick film of a negative photoresist LAX-1 available from Zeon Corporation was formed by spin coating, and a 0.5-$\mu$m-thick $SiO_2$ film was formed by sputtering. Then, etching was carried out in the same manner as above, to obtain 10-row barriers with a pitch of 1.0 mm in the direction perpendicular to the aluminum electrode. The barriers had a width of 300 $\mu$m, a height of 4.5 $\mu$m, and an overhang of 2 $\mu$m.

Films of a gold electrode/a butadiene compound (Compound 4)/an aluminum electrode were successively formed into thicknesses of 100 nm, 80 nm, and 100 nm as a diode element. Then, a capacitor of Example 1 was formed by oblique deposition as shown in Fig. 8c, and an organic insulating film was formed as shown in Fig. 8d. Films of copper phthalocyanine (CuPC)/naphthylphenyldiamine (NPB)/aluminum quinoline (Alq3) were deposited as a light-emitting element to thicknesses of 100 nm, 50 nm, and 50 nm respectively as shown in Fig. 8e, Li was deposited to a thickness of 5 nm, an organic insulating film was formed as shown in Fig. 8f, and an ITO film was formed thereon by sputtering as shown in Fig. 8g. Thus, a display device of Example 11 was obtained.

The conditions for obtaining an average luminance of 50 Cd/$m^2$ in the panel having the above structure are as follows. The conditions of scanning the entire panel were determined in the same manner as Example 1. The light-emitting element had an efficiency of approximately 2.0 Cd/A, so that a charge of $50 / 2.0 \times 4.2 \times 10^{-3} = 0.105$ Q/$m^2$ = 10.5 $\mu$Q/$cm^2$ or more had to be accumulated in the capacitor to maintain the light emission over the scan period of 4.2 msec. To inject the charge into the capacitor during the duty period of 0.42 msec, 25 mA/$cm^2$ or more of current has to be passed through the switching element. A current was passed through the light-emitting element also in the duty period practically, whereby these currents were superimposed on each other in the switching element to show the maximum current of approximately 28 mA/$cm^2$.

This was compared with the conventional structure. In the conventional structure, the area of the light-emitting element is half the area of this example like Example 1, so that the luminance of the light-emitting surface had to be 100 Cd/$m^2$, and the amount of the charge to be accumulated in the capacitor had to be approximately 21 $\mu$Q/$cm^2$, twice the value of this example.

Example 12

A 100-nm-thick ITO film was formed on a glass substrate by an RF magnetron sputtering method, and 15-column stripe electrodes with a pitch of 1.0 mm and a width of 0.7 mm were formed by a common photolithograph method. Further, a 100-nm-thick, 10-row capacitor region of barium strontium titanate oxide was formed by an RF magnetron sputtering method and a common photolithograph method such that the rows had a stripe structure with a pitch of 1.0 mm and a width of 0.6 mm. Then, a 100-nm-thick ITO electrode was formed by an RF magnetron sputtering method and a common photolithograph method such that the electrode had an island-like pixel shape. Further, the resultant was heat-treated for 1 hour in an oxygen atmosphere to obtain a capacitor. The capacitor was substantially transparent, and light emitted from a light-emitting portion 110 to be hereinafter formed is provided through the capacitor. Then a 4-$\mu$m-thick film of a negative photoresist LAX-1 available from Zeon Corporation was formed by spin coating, and a 0.5-$\mu$m-thick $SiO_2$ film was formed by sputtering. Then, etching was carried out in the same manner as above, to obtain 10-row barriers with a pitch of 1.0 mm in the direction perpendicular to the ITO electrode. The barriers had a width of 300 $\mu$m, a height of 4.5 $\mu$m, and an overhang of 2 $\mu$m. The capacitor was disposed between the barriers.

Films of copper phthalocyanine (CuPC)/naphthylphenyldiamine (NPB)/aluminum quinoline (Alq3) were deposited as a light-emitting element to thicknesses of 100 nm, 50 nm, and 50 nm, Li was deposited to a thickness of 5 nm, and films of a copper electrode/C60/an aluminum electrode were formed as a diode element to thicknesses of 100 nm, 80 nm, and 100 nm respectively.

The conditions for obtaining an average luminance of 70 Cd/$m^2$ in the panel having the above structure are as follows. The conditions of scanning the entire panel were determined in the same manner as Example 1. The light-emitting element had an efficiency of approximately 2.0 Cd/A, so that a charge of $70/2.0 \times 4.2 \times 10^{-3} = 0.147$ Q/$m^2$ = 14.7 $\mu$Q/$cm^2$ or more had to be accumulated in the capacitor to maintain the light emission over the scan period of 4.2

msec. To inject the charge into the capacitor during the duty period of 0.42 msec, 35 mA/cm$^2$ or more of current has to be passed through the switching element. A current was passed through the light-emitting element also in the duty period practically, whereby these currents were superimposed on each other in the switching element to show the maximum current of approximately 37 mA/cm$^2$.

This was compared with the conventional structure. In the conventional structure, the area of the light-emitting element is half the area of this example like Example 1, so that the luminance of the light-emitting surface had to be 140 Cd/m$^2$, and the amount of the charge to be accumulated in the capacitor had to be approximately 30 μQ/cm$^2$, twice the value of this example.

In Example 1, the luminance of the light-emitting element required for obtaining the same average luminance was 1/2 of that of the structure shown in Fig. 1 according to Embodiment 1, so that it can be expected that the element lifetime be approximately doubled. Alternatively, double luminance can be obtained with the same lifetime.

Embodiment 3

Summary

An example of the driving method of the invention is described with reference to Fig. 18. The driving method may be used for e.g. the structure shown in Fig. 6. Fig. 6 shows the equivalent circuit using the rectifier 602 as the switching element, and Fig. 18 shows the waveform of a voltage applied to the column electrode (the data signal line or Y electrode) 116 in a pixel in one frame period (Fig. 18a), the waveform of a voltage applied to the row electrode (the timing signal line or X electrode) 104 (Fig. 18e), the waveform of a voltage applied to a connection A between the light-emitting portion 110 and the switching element 114 (Fig. 19c), calculated therefrom, and potential differences thereof (Figs. 18b and 18d). The emission state of the light-emitting portion 110 is also shown in Fig. 18e.

Further, the changes in the duty period shown in Figs. 18a to 18f are enlarged in the time direction and shown in detail in Figs. 19a to 19f. The rectifier 602 (Fig. 6) has such nonlinearity that the resistance is smaller within a higher voltage region. A negative bias -VXon is applied to the timing signal line X (the row electrode) 104 in the latter part 705 of the duty period 702 (Fig. 19e), whereby the resistance of the rectifier is reduced to convert to the conducting state. When VYon represents a voltage applied to the data signal line 116 (Fig. 19a), the potential difference between X and Y (not shown) is VXon + VYon. When the electrical connection between the rectifier 602, the light-emitting element 110, and the capacitor 106 is referred to as a position A (Fig. 6), in a case where the rectifier has a forward resistance sufficiently smaller than that of the light-emitting element, the data signal line Y 116 and the position A have almost the same potentials. As a result, the potential of the position A becomes VAon near the potential of Y, and the potential difference between A and X becomes (VXon + VAon). In the off duty period 704, the voltage of the timing signal line X 104 is changed from VXon to 0 V, and at this time, the position A is in the insulating state (in other words, the position A is a bias reverse to the rectifier), so that there is no exchange of the charge. As a result, the voltage of the position A is reduced by Vxon to (VXon + VAon).

In the off duty period 704, no bias is applied to the timing signal line X 104 and the data signal line Y 116, and the device is driven at low voltage, whereby the rectifier 602 is in substantially non-conducting state. At this time, the emission intensity of each pixel can be controlled by VYon per the pixel.

As described above, when a frame period is controlled to the emission state, a charge remains in the capacitor at the end of the frame period and may affect the emission state or the non-emission state in the next frame period. Particularly in a case where the next frame period is in the non-emission state, the record of the previous emission state has to be eliminated by an appropriate quenching signal. For example, as shown in Fig. 7, the duty period of each row is divided into two of the former part 706 and the latter part 705, and the remaining charge is released in the former part 706. The signal for the next frame period may be applied in the latter part 705 of the duty period, to obtain a desired display in the next frame.

Details

In the driving method of this embodiment, bias voltages of -VXe, -VYe are applied to both or one of the timing signal line X (the row electrode) 104 and the data signal line Y (the column electrode) 116 respectively (Figs. 19a and 19c). Thus, the charge remaining in the capacitor is released from the light-emitting element 110, whereby the above problem can be solved. When the potential remaining in the position A at the end of the preceding off duty period is referred to as VAr (Fig. 19c), the bias voltages -VXe and -VYe are applied to the timing signal line X (the row electrode) 104 and the data signal line Y (the column electrode) 116 respectively, so that the potential difference between A and X becomes VAr + VXe and the potential difference between Y and A becomes -VAr- VYe. A current is passed in the forward direction of the rectifier from A to X because the potential difference between A and X is VAr + VXe, while no current is passed from Y to A under the reverse bias. The potential difference between A and X is larger than VAr in the off duty period, whereby the discharge proceeds rapidly, and the potential of A comes close to that of X. Particularly in the case of VXe < VYe, when the potential of A reaches -VYe, a charge is injected from Y through the rectifier 602 and the potential is not lowered any more. In this case, though the potential of A can be further stabilized, it is possible that, after the potential reaches a constant value, a current is passed from Y to X and the light-emitting portion 106 continuously emits light, thereby reducing the contrast ratio (the on/off ratio). On the contrary, in the case of VXe > VYe (Fig. 19d), the charge

injection from Y is reduced and only the remaining charge contributes to the light emission, so that the contrast ratio can be easily controlled. In every case, because VYe is applied through the data signal line Y (the column electrode) 116, the record of each pixel can be incorporated and the optimum value can be selected depending on the desired image quality.

In this embodiment, the structure of the rectifier is preferably a stack structure of an aluminum thin film/a fullerene thin film/a copper thin film, a stack structure of an aluminum electrode/a pentacene compound/a gold electrode, etc., though it is not limited thereto and various organic electronic materials may be used therefor.

The capacitor may comprise various oxides and mixed oxides of metals such as silicon, aluminum, tantalum, titanium, strontium, and barium. Further, the capacitor may comprise conductive fine particles dispersed in an organic material, which can increase the effective dielectric constant of the dielectric layer, to form the capacitor portion with a small area and a sufficient capacity. Particularly the capacitor of the latter material can be formed by a low temperature process, and is preferred for a plastic substrate.

In this embodiment, in the duty period, a charge corresponding to the emission amount is accumulated through the first rectifier in the capacitor of the pixel according to the row to be duty-driven in the matrix. In the periods other than the duty period, a current for the light-emitting portion is maintained by the potential accumulated in the capacitor, to emit light continuously.

In this embodiment, a rectifier capable of fast operation is used as the switching element. In the case of using a heat resistant material such as glass for the substrate, the capacitor may comprise a ceramic oxide. For example, an excellent capacitor can be obtained by forming a typical ferroelectric material of barium strontium titanate into a several hundred nanometer-thick film using an RF magnetron sputtering method, and by heat-treating the film at approximately 650°C. In the case of using a plastic substrate, the capacitor may comprise a dielectric material layer containing an organic dielectric material and conductive fine particles dispersed therein.

In the duty period of each row, the charge is accumulated through the rectifier in the capacitor connected in parallel with each light-emitting portion. In the off duty period, each pixel is electrically isolated from the signal line (e.g. the column electrode) by the rectifier, and continuously emits light by using the charge accumulated in the capacitor. The amount of the charge accumulated may be controlled depending on the desired emission intensity, and thereby multiple tones can be displayed easily.

Fig. 21 is a cross-sectional view showing an example of the structure of one pixel of the display device according to this embodiment. A row electrode 104 comprising a transparent electrode material of ITO (indium tin oxide) is formed on one surface of a transparent substrate 102. The row electrode 104 is patterned into a plurality of stripe electrodes in parallel with each other. A barrier 108 is formed by photoresist, etc. on and around the formed row electrode 104. Then, a light-emitting portion 110 comprising an organic EL element, etc. and a capacitor portion 106 are apposed on the row electrode 104 and separated by the barrier. Next an island-like electrode face (a pixel electrode) 112 divided for each pixel, and a thin film rectifier 602 are formed. Further, a column electrode 116, which comprises a metal patterned into a plurality of stripe electrodes in parallel with each other, is formed on the rectifier 602 crosswise to the row electrode 104. The electrodes, the organic EL element, the rectifier, the capacitor portion, etc. are thin films, and current is passed through the organic EL element, the thin film rectifier, etc. in the direction perpendicular to the film surface.

Example 13

100 stripe electrodes comprising a transparent electrode of ITO (indium tin oxide) were formed as a row electrode on a polyethylene terephthalate substrate by a common photo process and sputtering. The 100 electrodes had a pitch of 500 μm, a width of 450 μm, and a thickness of 100 nm. Then, 100 insulating barriers were formed by a photo process in the longitudinal direction of the electrodes. The pattern pitch was 500 μm, and the electrodes were divided into two regions by the barriers, to form 100 x 100 pixels. Then, the two regions divided in the longitudinal direction were used in combination, and a light-emitting element was formed on one region and a capacitor was formed on the other region, on the ITO electrodes. They had the same areas of 220 μm x 450 μm.

Films of copper phthalocyanine (CuPC, available from Aldrich)/naphthylphenyldiamine (NPB, available from Aldrich)/aluminum quinoline (Alq3, available from Aldrich)/a calcium electrode were successively formed by vacuum deposition to form an organic EL layer as a light-emitting element. The films had thicknesses of 100 nm, 50 nm, 50 nm, and 100 nm respectively.

An organic insulating material of aminoimidazole dicyanate (Compound 1) and conductive fine particles of aluminum were co-deposited by a vacuum deposition method to form a dielectric material layer of a capacitor element. Specifically, thin films of an aluminum layer, an aminoimidazole dicyanate layer, a co-deposited layer of aminoimidazole dicyanate and aluminum, an aminoimidazole dicyanate layer, and an aluminum layer were formed successively. The films had thicknesses of 60 nm, 40 nm, 30 nm, 40 nm, and 60 nm respectively.

A 120-nm-thick film of C60 available from Aldrich and a 60-nm-thick Cu electrode were formed on an aluminum electrode to obtain a rectifier. Then, a column electrode 116 was formed by depositing aluminum. The deposition step

was carried out by a diffusion pump exhaust apparatus at a vacuum degree of 4 x $10^{-4}$ Pa (3 x $10^{-6}$ torr). Aluminum was deposited by a resistance heating method at a film forming speed of 30 nm/sec, and aminoimidazole dicyanate layer containing the conductive fine particles of aluminum was formed by a co-deposition method. The deposition was carried out by a resistance heating method, aminoimidazole dicyanate was deposited at a film forming speed of 20 nm/sec, and aluminum was deposited at 10 nm/sec.

Example 14

A sample of Example 14 was produced in the same manner as Example 13 except that an aluminum film (100 nm), a pentacene film (50 nm), and a gold film (100 nm) were successively deposited as a rectifier.

Example 15

On a substrate of glass, 50 transparent stripe electrodes of ITO (indium tin oxide) were alternately formed as row electrodes, a 50-nm-thick platinum film was formed on the ITO electrodes, a 100-nm-thick barium strontium titanate oxide film was formed on the platinum film by an RF magnetron sputtering method and a common photolithograph method, and the resultant was heat-treated for 1 hour in an oxygen atmosphere to obtain a capacitor. A sample of Example 15 was produced in the same manner as Example 13 except therefor.

The samples of Examples were driven under conditions of a frame frequency of 60 Hz and a frame period of approximately 17 ms. The duty period of each row was 17/100 ms = 170 μs. The resistance of the rectifier, the capacitance, and the time constant of the charging process obtained therefrom, of each Example were shown in Table 1, and the samples could make a sufficient response in the duty period of 170 μs.

Table 1

| | Resistance of rectifier | Capacitance | Time constant |
|---|---|---|---|
| Example 13 | 500 Ω | 0.5 nF | 0.25 μs |
| Example 14 | 2000 Ω | 0.5 nF | 1.0 μs |
| Example 15 | 500 Ω | 5 nF | 20 μs |

The time constant of the discharging process in the off duty period of each Example is shown in Table 2. It should be noted that the resistance of the organic EL element was an approximated value obtained by approximation to a straight line within the range of voltage 8 V or less.

Table 2

| | Resistance of organic EL element | Capacitance | Time constant |
|---|---|---|---|
| Example 13 | 800 kΩ | 0.5 nF | 0.4 ms |
| Example 14 | 800 kΩ | 0.5 nF | 0.4 ms |
| Example 15 | 800 kΩ | 5 nF | 4.0 ms |

Though the time constant of the discharging process was sufficiently small as compared with the frame period of 17 ms in the above test calculation, the discharge of the capacitor was not completed in each frame period because the organic EL element had a larger resistance at lower voltage as described above. The residual voltage and the voltage application conditions according to the invention of each Example, and the properties obtained by not using the method of the invention of Comparative Examples 1, 2, and 3 are shown in the following table. It is clear that, by using the driving method of the invention, the influence of the residual voltage was reduced to obtain a high on/off ratio. The on/off ratio is an emission intensity ratio obtained by alternately repeating the emission state shown in the following table and the non-emission state where VYon is equal to - VXon. The on/off ratio corresponds to emission intensity by rest potential in the case of not using the method of the invention. As is clear from Table 3, the influence of the rest potential could be prevented by the driving method of the invention. Further, it is clear that most of the charge accumulated in the capacitor was released through the light-emitting element, thereby reducing the power consumption.

Table 3

| | VAr | VXe | VYe | VXon | VYon | VAon | on/off ratio |
|---|---|---|---|---|---|---|---|
| Example 13 | 3.9 | 5.0 | 0.6 | 8.0 | 0.0 | -0.01 | $2 \times 10^4$ |
| Comparative Example 1 | 4.2 | 0.0 | 0.0 | 8.0 | 0.0 | -0.01 | $6 \times 10^2$ |
| Example 14 | 4.3 | 5.0 | 0.6 | 10.0 | 0.0 | -0.08 | $4 \times 10^3$ |
| Comparative Example 2 | 5.4 | 0.0 | 0.0 | 10.0 | 0.0 | -0.08 | $3 \times 10^2$ |
| Example 15 | 7.2 | 5.0 | 0.7 | 8.0 | 0.0 | -0.01 | $1 \times 10^3$ |
| Comparative Example 3 | 7.7 | 0.0 | 0.0 | 8.0 | 0.0 | -0.01 | $2 \times 10^1$ |

Though in above Examples the rectifier and the organic EL element had polarities reverse to those of Fig. 2, and thus also the voltage values had polarities reverse to those of Figs. 1 and 7, the values are shown in the above table in accordance with the polarities of Figs. 1 and 7 to facilitate understanding.

Industrial Applicability

According to the present invention, there is provided the method for driving a display device such as an organic EL display panel using a rectifier, which can achieve a stable light emission with a low cost, a high contrast ratio (on/off ratio), and a small power consumption.

## Claims

1. A display device comprising, on a substrate,
first stripe electrodes formed in parallel with each other,
second stripe electrodes formed in parallel with each other crosswise to the first stripe electrodes, and
a plurality of pixels formed at spatial intersections between each of the first stripe electrodes and each of the second stripe electrodes,
wherein each of the pixels comprises
a switching element comprising a two-terminal nonlinear element connected electrically to one of the first stripe electrodes,
a light-emitting portion connected electrically to the switching element and one of the second stripe electrodes, and
a capacitor portion comprising an organic dielectric material as a dielectric layer, connected electrically to the switching element and the one of the second stripe electrodes electrically in parallel with the light-emitting portion.

2. A display device comprising, on a substrate,
first stripe electrodes formed in parallel with each other,
second stripe electrodes formed in parallel with each other crosswise to the first stripe electrodes, and
a plurality of pixels formed at spatial intersections between each of the first stripe electrodes and each of the second stripe electrodes,
wherein each of the pixels comprises
a switching element comprising a two-terminal nonlinear element connected electrically to one of the first stripe electrodes,
a light-emitting portion connected electrically to the switching element and one of the second stripe electrodes, and
a capacitor portion comprising barium strontium titanate oxide as a dielectric layer, connected electrically to the switching element and the one of the second stripe electrodes electrically in parallel with the light-emitting portion.

3. The display device according to claim 1, wherein the dielectric layer comprises a large number of conductive fine particles dispersed.

4. The display device according to claim 1 or 2, wherein the switching element is a bistable element or a diode element.

5. The display device according to claim 4, wherein the diode element comprises C60 or pentacene.

6. The display device according to claim 1 or 2, wherein the light-emitting portion and the capacitor portion are in the

same plane.

**7.** The display device according to claim 1 or 2, wherein the substrate is a flexible substrate.

**8.** The display device according to claim 1 or 2, wherein the light-emitting portion, the capacitor portion, and the switching element are thin films formed on the substrate and have electrode layers on both sides,
the light-emitting portion, the capacitor portion, and the switching element are stacked on the substrate in this order or the reverse order together with the electrode layers,
the capacitor portion-facing electrode of the light-emitting portion and the capacitor portion-facing electrode of the switching element are electrically connected by a first via in the capacitor portion,
the light-emitting portion-facing electrode of the capacitor portion and the one of the second stripe electrodes are electrically connected by a second via in the light-emitting portion, and
the display device further comprises an insulation portion for insulating the light-emitting portion from the capacitor portion.

**9.** The display device according to claim 8, wherein the first via is formed along a side of the capacitor portion through a side surface of the capacitor portion and is lined with an insulating material,
the second via is formed along a side of the light-emitting portion through a side surface of the light-emitting portion and is lined with an insulating material, and
the insulating materials are continuous with the insulation portion.

**10.** The display device according to claim 9, wherein the display device comprises an electrode layer as the first or second stripe electrodes on the substrate, and further comprises electrically insulating barriers, which extend crosswise to the stripe electrodes of the electrode layer, divide adjacent pixels in the direction of the stripe electrodes of the electrode layer, and have an overhang portion protruding in parallel with the substrate at the top.

**11.** A method for producing the display device of claim 10, comprising the steps of
forming the light-emitting portion having the electrode layers by oblique deposition using the barrier as a mask,
forming the insulation portion by oblique deposition using the barrier as a mask,
forming the capacitor portion having the electrode layers by oblique deposition using the barrier as a mask, and
forming the switching element having the electrode layers by oblique deposition using the barrier as a mask.

**12.** A method for driving the display device of any one of claims 1 to 10,
wherein the display device is a dot matrix display device using a duty drive system such that each of the pixels is addressed by a respective row electrode and a respective column electrode of the combination of the first and second stripe electrodes,
the method comprises, in a duty period of a selected row,
the first step of applying a signal for converting the switching element to a conducting state by the row electrode, the column electrode, or both thereof,
the second step of accumulating a charge for emission of the light-emitting portion in the capacitor portion through the conducting-state switching element by the row electrode, the column electrode, or both thereof, and
the third step of applying a signal for converting the switching element to a non-conducting state by the row electrode, the column electrode, or both thereof, and
the method comprises, in an off duty period of the selected row, the step of releasing the charge accumulated in the capacitor portion from the light-emitting portion to emit light therefrom.

**13.** The method for driving the display device according to claim 12, wherein in the first step a voltage offset signal is applied to the row electrodes of rows other than the selected row, the voltage offset signal having a polarity equal to that of a voltage signal applied to the column electrode.

**14.** The method for driving the display device according to claim 12, wherein in the first step a voltage offset signal is applied to the row electrode of the selected row, the voltage offset signal having a polarity reverse to that of a voltage signal applied to the column electrode.

**15.** The method for driving the display device according to claim 12, wherein in the third step a voltage offset signal is applied to the row electrodes of rows other than the selected row, the voltage offset signal having a polarity equal to that of a voltage signal applied to the column electrode.

**16.** The method for driving the display device according to claim 12, wherein in the third step a voltage offset signal is applied to the row electrode of the selected row, the voltage offset signal having a polarity reverse to that of a voltage signal applied to the column electrode.

**17.** A method for driving the display device of any one of claims 1 to 10,
wherein the display device is a dot matrix display device using a duty drive system such that each of the pixels is addressed by a respective row electrode and a respective column electrode of the combination of the first and second stripe electrodes,
the method comprises, in a duty period of a selected row in a frame period,
the first step of applying a reverse bias voltage to the switching element, accumulating a charge through the switching element in the capacitor portion, and applying a signal for making the charge releasable by the row electrode, the column electrode, or both thereof, and
the second step of applying a forward bias voltage to the switching element to convert the switching element to a conducting state, thereby accumulating a charge for emission of the light-emitting portion in the capacitor portion through the conducting-state switching element by the row electrode, the column electrode, or both thereof,
the method comprises, in an off duty period of the selected row in the frame period, the step of releasing the charge accumulated in the capacitor portion from the light-emitting portion to emit light therefrom, and
in a duty period of a next frame period, the residual charge remaining in the capacitor portion corresponding to the selected row is released by the first step.

**18.** The method for driving the display device according to claim 17, wherein in the first step a voltage offset signal is applied to the row electrodes of rows other than the selected row, the voltage offset signal having a polarity equal to that of a voltage signal applied to the column electrode.

**19.** The method for driving the display device according to claim 17, wherein in the first step a voltage offset signal is applied to the row electrode of the selected row, the voltage offset signal having a polarity reverse to that of a voltage signal applied to the column electrode.

**20.** The method for driving the display device according to claim 17, wherein in the second step a voltage offset signal is applied to the row electrodes of rows other than the selected row, the voltage offset signal having a polarity equal to that of a voltage signal applied to the column electrode.

**21.** The method for driving the display device according to claim 17, wherein in the second step a voltage offset signal is applied to the row electrode of the selected row, the voltage offset signal having a polarity reverse to that of a voltage signal applied to the column electrode.

**22.** A method for driving a display device comprising a first electrode, a second electrode, a rectifier connected electrically to the first electrode, a light-emitting portion connected electrically to the rectifier and the second electrode, and a capacitor portion connected electrically to the rectifier and the second electrode electrically in parallel with the light-emitting portion,
wherein the method comprises, in a duty period,
the first step of applying a voltage offset signal to the first electrode and/or the second electrode to release a charge remaining in the capacitor portion from the light-emitting portion, and
the second step of accumulating a charge for emission of the light-emitting portion in the capacitor portion, and
the method comprises, in an off duty period, the step of releasing the charge accumulated in the capacitor portion from the light-emitting portion to emit light therefrom.

**23.** The method for driving a display device according to claim 22, **characterized in that**
the first electrode is one of first stripe electrodes formed in parallel with each other,
the second electrode is one of second stripe electrodes formed in parallel with each other crosswise to the first stripe electrodes,
the display device comprises on a substrate a plurality of pixels formed at overlaps between each of the first stripe electrodes and each of the second stripe electrodes,
the rectifier is connected electrically to one of the first stripe electrodes and disposed in each of the pixels,
the light-emitting portion is connected electrically to the rectifier and one of the second stripe electrodes and disposed in each of the pixels,
the capacitor portion is connected electrically to the rectifier and the one of the second stripe electrodes in parallel with the light-emitting portion, and disposed in each of the pixels, and

the display device is a dot matrix display device using a duty drive system such that each of the pixels is addressed by a respective row electrode and a respective column electrode of the combination of the first and second stripe electrodes.

FIG. 1

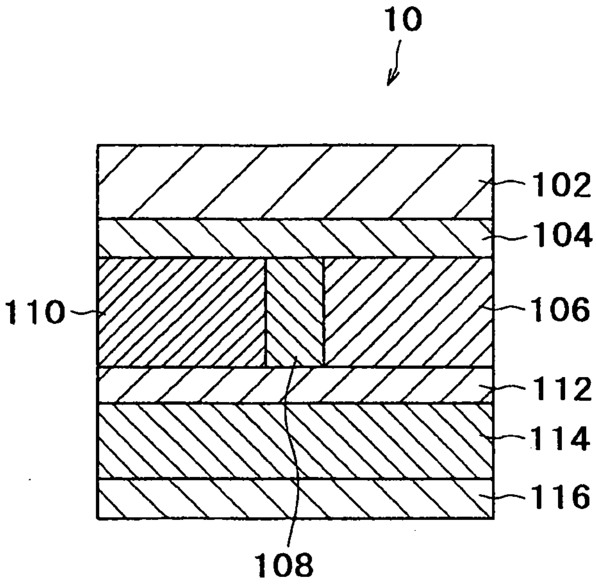
10
102
104
110
106
112
114
116
108

FIG. 2

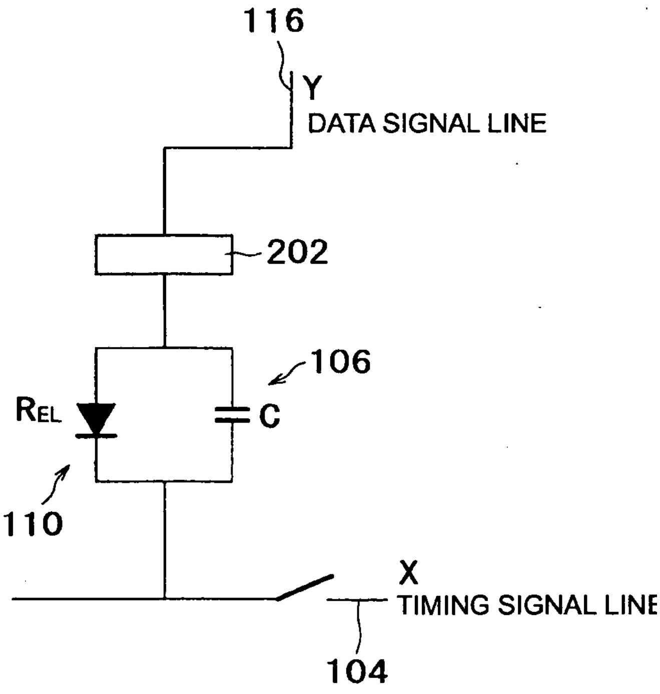
116
Y
DATA SIGNAL LINE
202
106
REL
C
110
X
TIMING SIGNAL LINE
104

FIG. 3

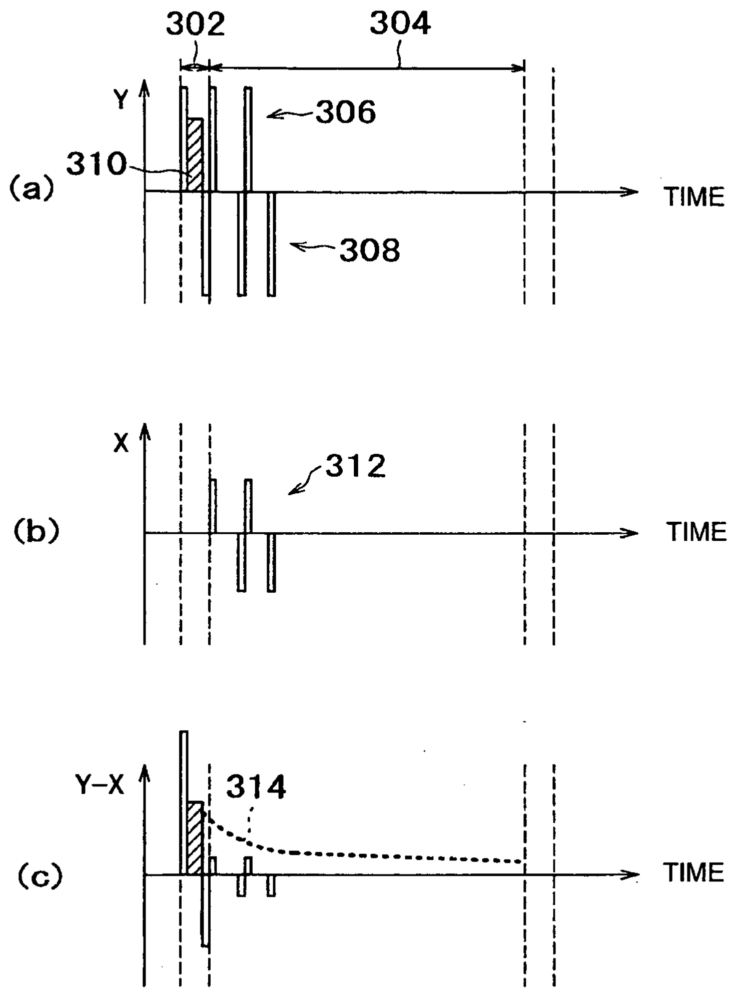
302
304
Y
306
310
(a)
TIME
308
X
312
(b)
TIME
Y−X
314
(c)
TIME

FIG. 4

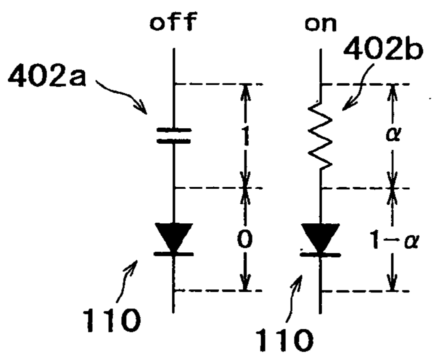
off
on
402a
402b
1
α
0
1−α
110
110

FIG. 5

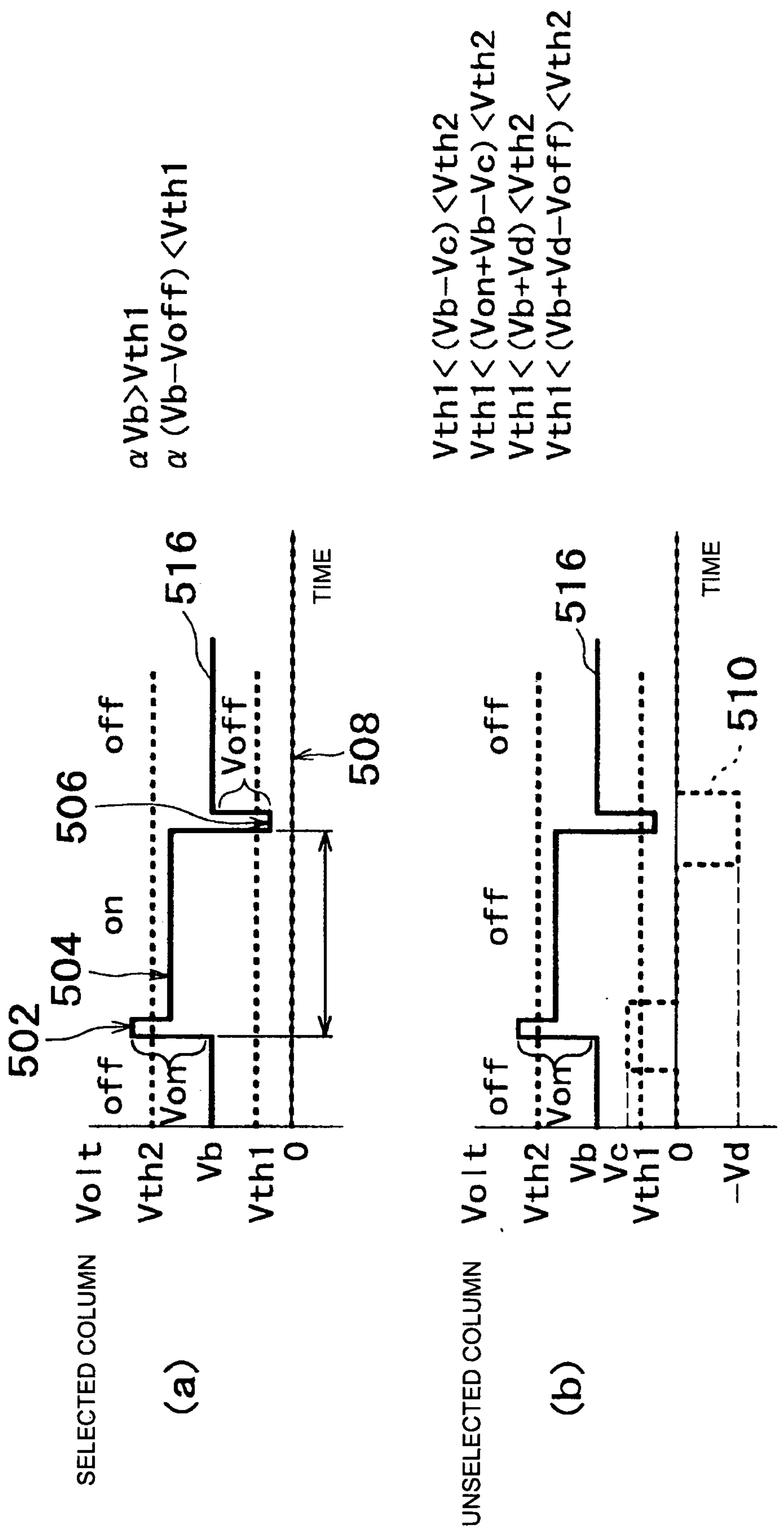
(a)
SELECTED COLUMN
Volt
Vth2
Vb
Vth1
0
off
on
off
Von
Voff
502
504
506
508
516
TIME
αVb>Vth1
α(Vb−Voff)<Vth1
(b)
UNSELECTED COLUMN
Volt
Vth2
Vb
Vc
Vth1
0
−Vd
off
off
off
Von
510
516
TIME
Vth1<(Vb−Vc)<Vth2
Vth1<(Von+Vb−Vc)<Vth2
Vth1<(Vb+Vd)<Vth2
Vth1<(Vb+Vd−Voff)<Vth2

FIG. 6

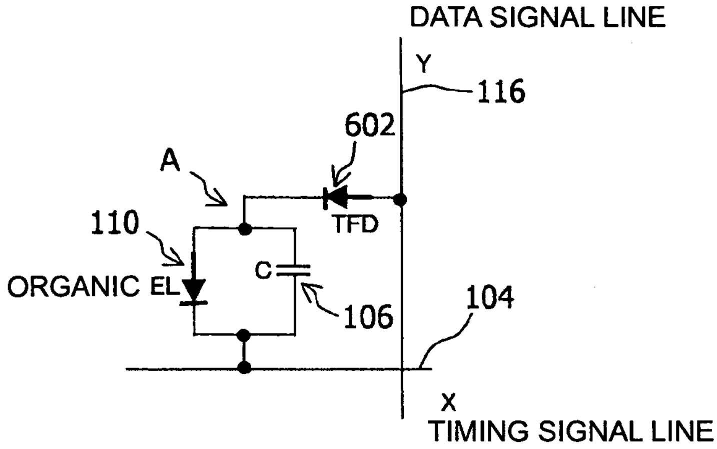
DATA SIGNAL LINE
Y
116
602
A
110
TFD
ORGANIC EL
C
106
104
X
TIMING SIGNAL LINE

FIG. 7

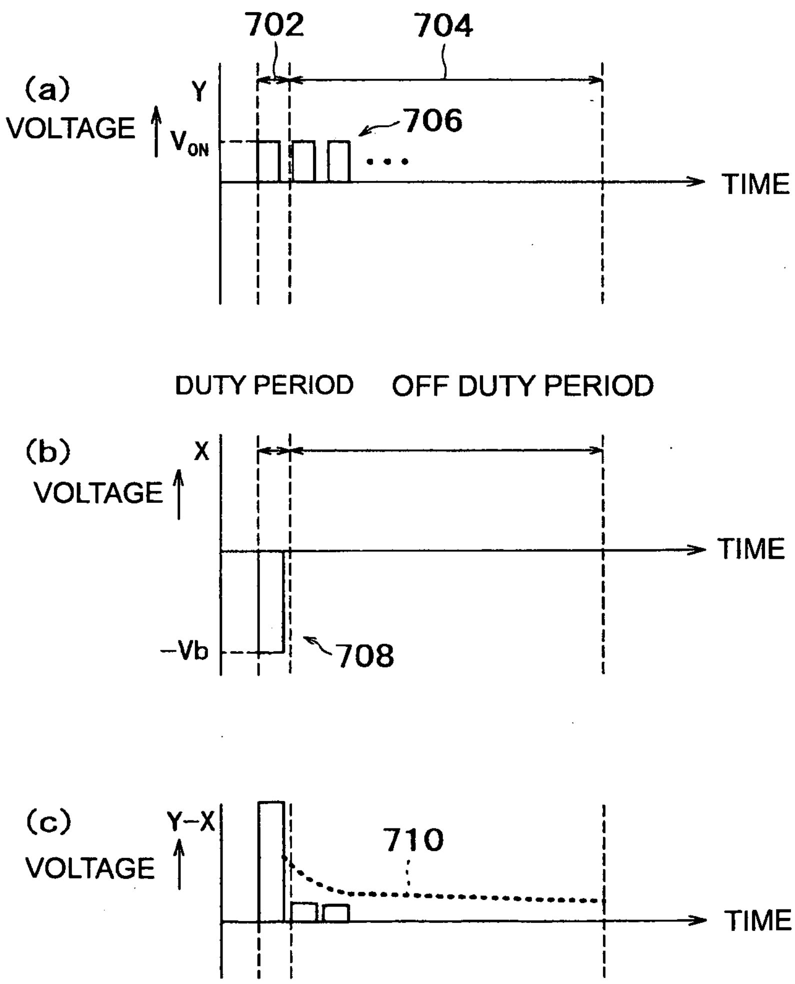
702
704
(a)
Y
VOLTAGE
$V_{ON}$
706
TIME
DUTY PERIOD
OFF DUTY PERIOD
(b)
X
VOLTAGE
TIME
−Vb
708
(c)
Y−X
VOLTAGE
710
TIME

FIG. 8

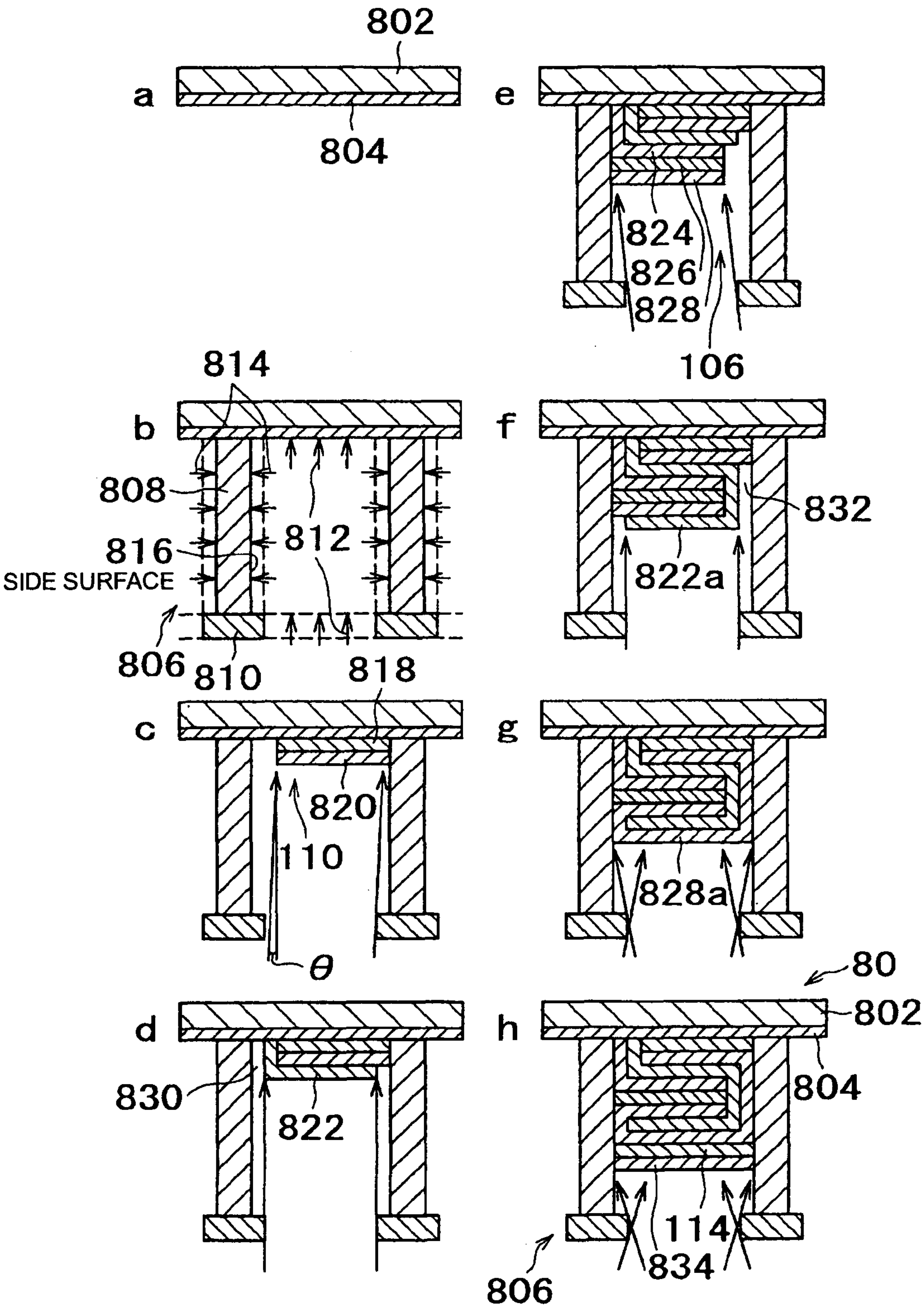

802
a
804
e
824
826
828
106
814
b
808
816
SIDE SURFACE
812
806
810
818
f
832
822a
c
820
110
θ
g
828a
80
d
830
822
h
802
804
114
834
806

FIG. 9

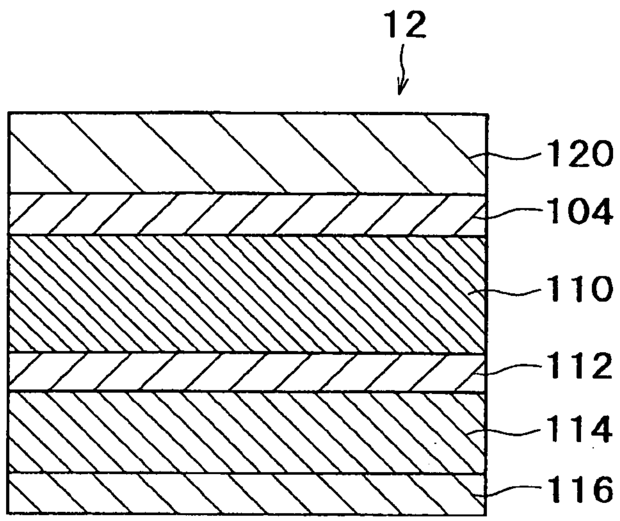


FIG. 10

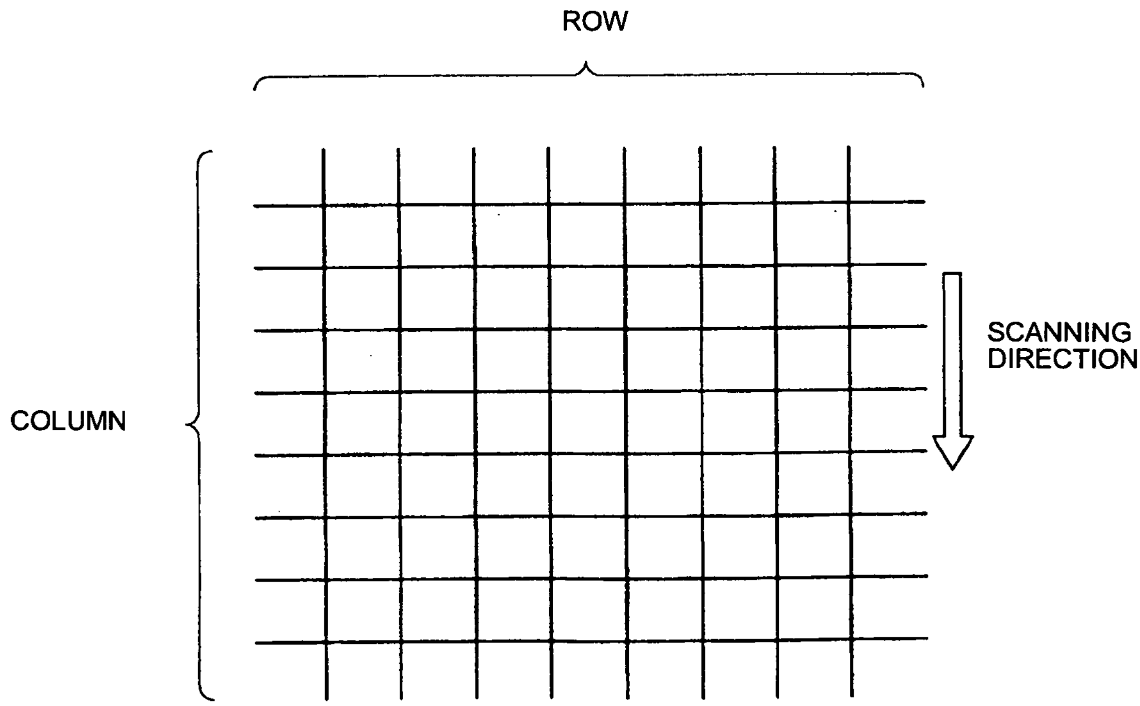

FIG. 11

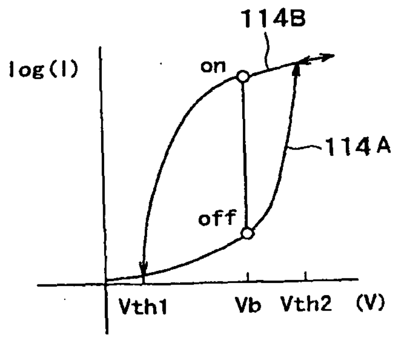
114B
log(I)
on
114A
off
Vth1
Vb
Vth2
(V)

FIG. 12

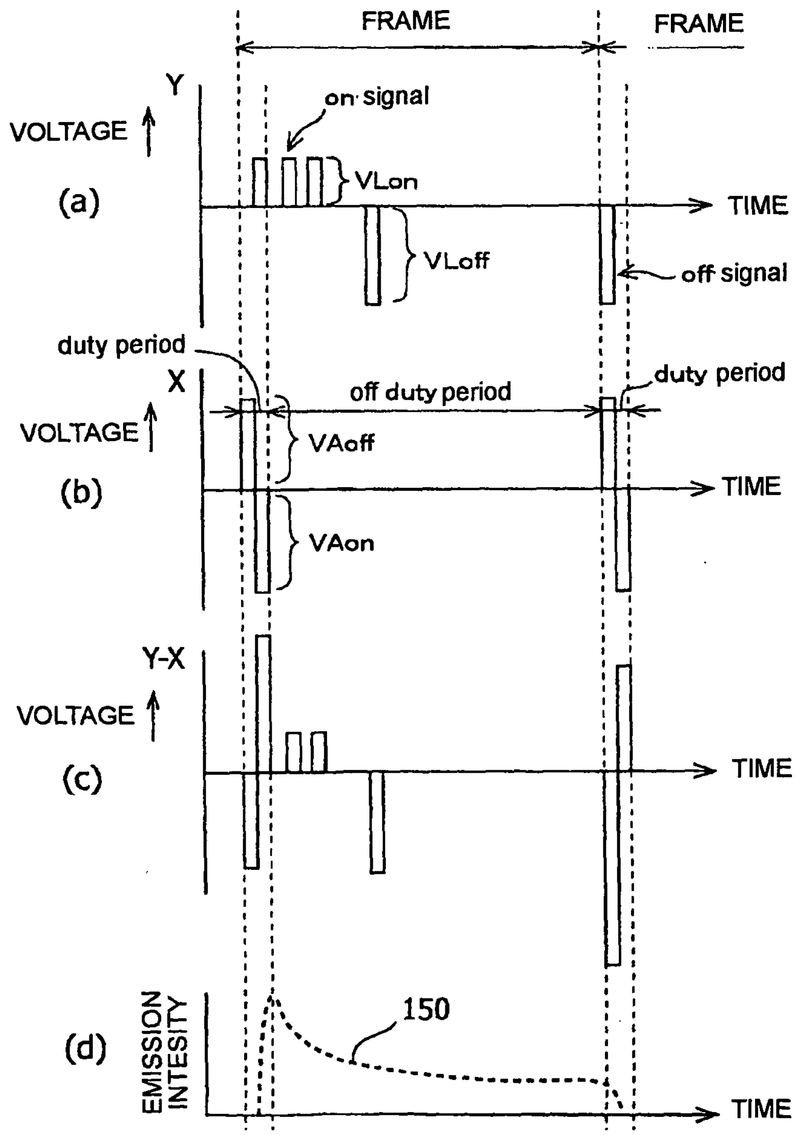
FRAME
FRAME
Y
VOLTAGE
on signal
(a)
VLon
TIME
VLoff
off signal
duty period
X
duty period
off duty period
VOLTAGE
VAoff
(b)
TIME
VAon
Y-X
VOLTAGE
(c)
TIME
(d)
EMISSION INTESITY
150
TIME

# FIG. 13

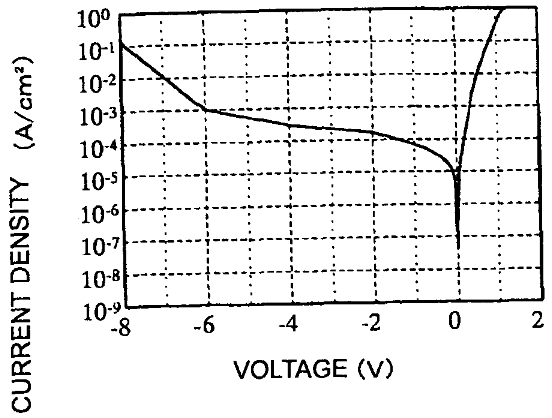


# FIG. 14

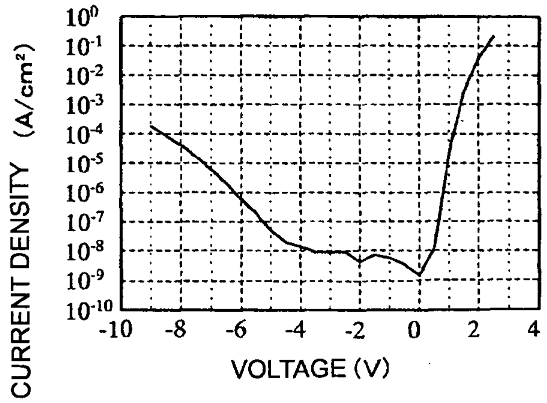


# FIG. 15

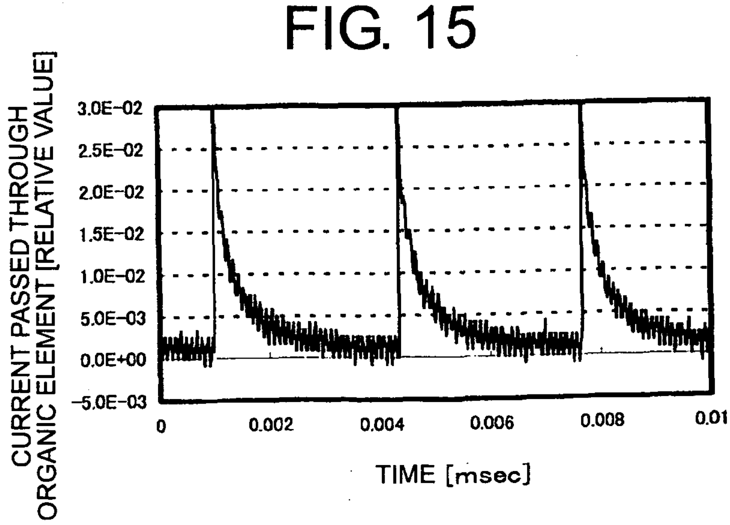

FIG. 16

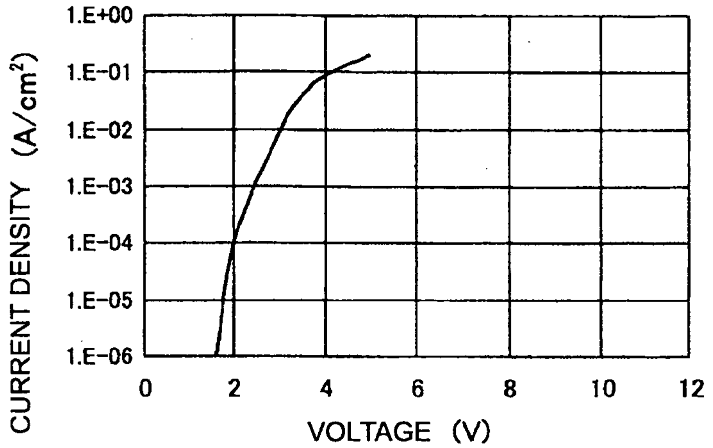
1.E+00
1.E-01
1.E-02
1.E-03
1.E-04
1.E-05
1.E-06
0
2
4
6
8
10
12
VOLTAGE (V)
CURRENT DENSITY (A/cm2)

FIG. 17

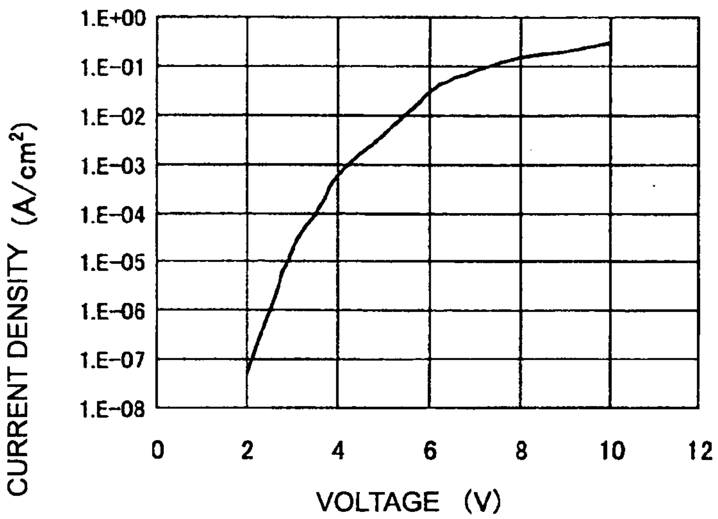
1.E+00
1.E-01
1.E-02
1.E-03
1.E-04
1.E-05
1.E-06
1.E-07
1.E-08
0
2
4
6
8
10
12
VOLTAGE (V)
CURRENT DENSITY (A/cm2)

FIG. 18

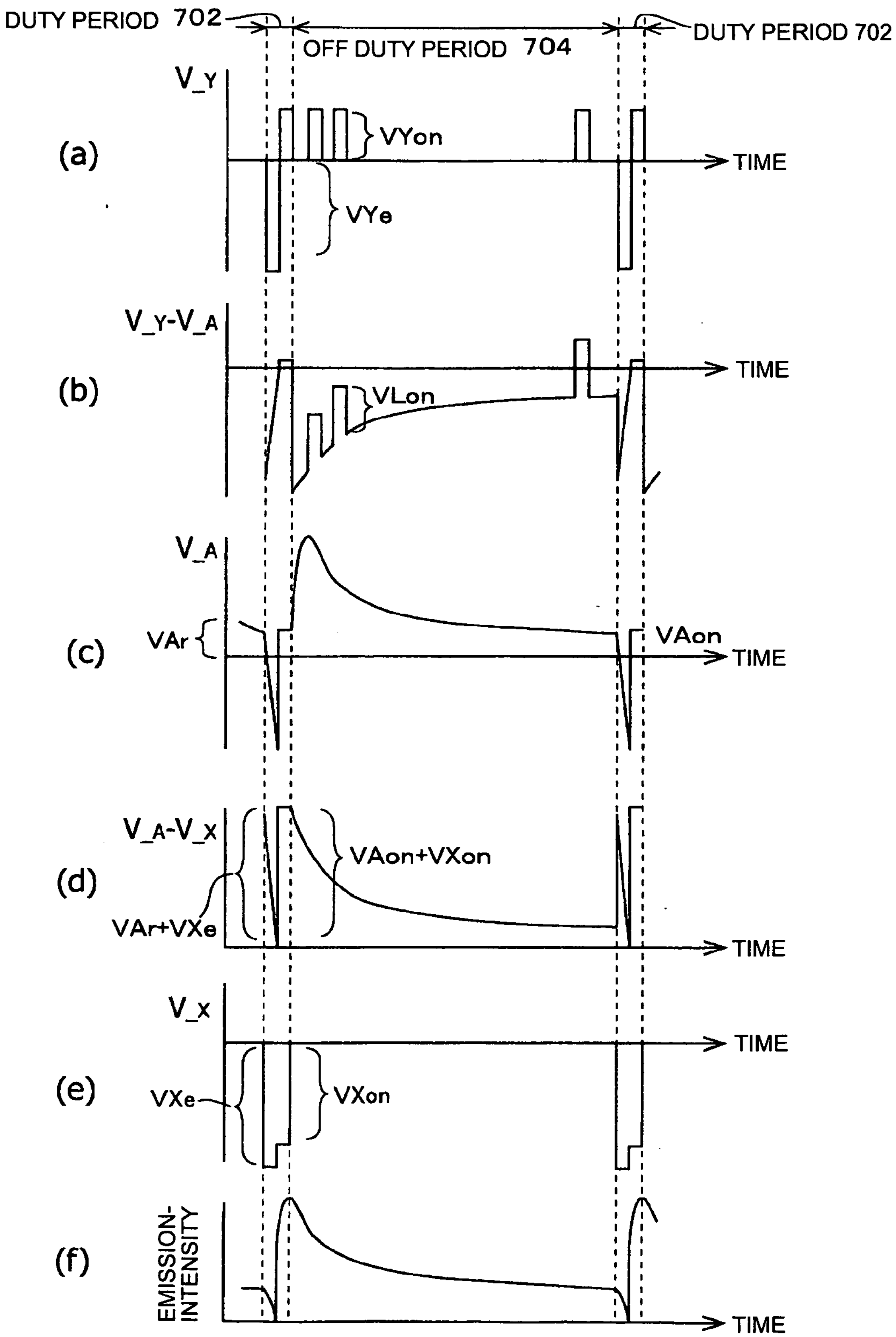
DUTY PERIOD 702
OFF DUTY PERIOD 704
DUTY PERIOD 702
V_Y
(a)
VYon
VYe
TIME
V_Y-V_A
(b)
VLon
TIME
V_A
(c)
VAr
VAon
TIME
V_A-V_X
(d)
VAon+VXon
VAr+VXe
TIME
V_X
(e)
VXe
VXon
TIME
(f)
EMISSION-INTENSITY
TIME

FIG. 19

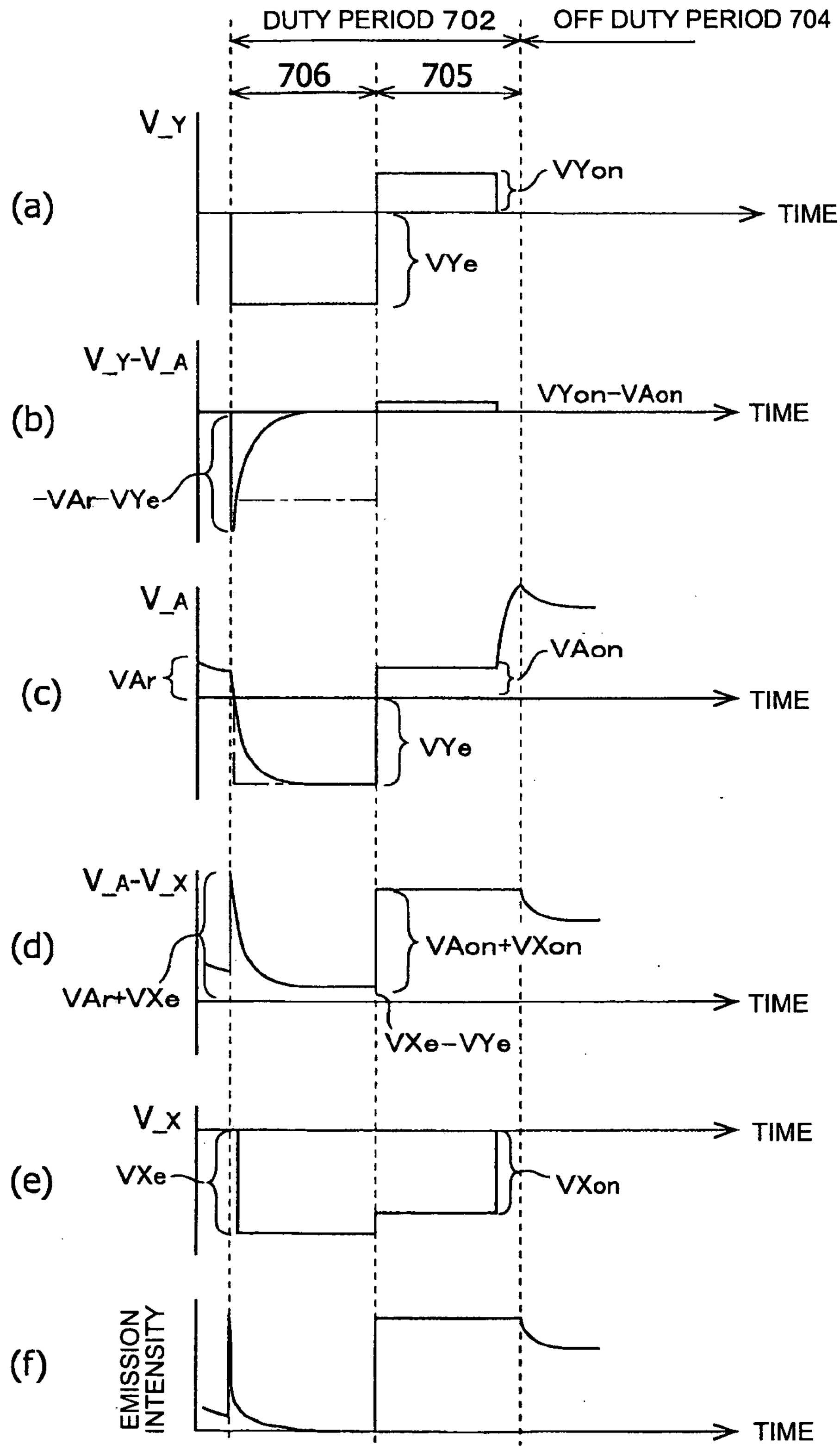
DUTY PERIOD 702
OFF DUTY PERIOD 704
706
705
V_Y
(a)
VYon
TIME
VYe
V_Y-V_A
(b)
VYon−VAon
TIME
−VAr−VYe
V_A
(c)
VAr
VAon
TIME
VYe
V_A-V_X
(d)
VAon+VXon
VAr+VXe
TIME
VXe−VYe
V_X
TIME
(e)
VXe
VXon
(f)
EMISSION INTENSITY
TIME

FIG. 20

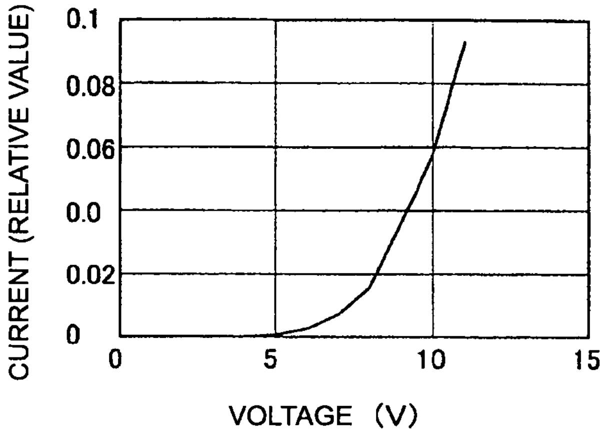
CURRENT (RELATIVE VALUE)
0.1
0.08
0.06
0.0
0.02
0
0
5
10
15
VOLTAGE (V)

FIG. 21

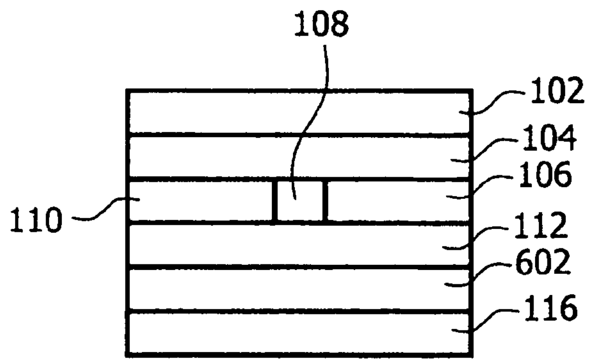
108
102
104
106
110
112
602
116

## INTERNATIONAL SEARCH REPORT

International application No.
PCT/JP2004/011603

A. CLASSIFICATION OF SUBJECT MATTER
Int.Cl[7] G09F9/30, G09G3/30

According to International Patent Classification (IPC) or to both national classification and IPC

B. FIELDS SEARCHED

Minimum documentation searched (classification system followed by classification symbols)
Int.Cl[7] G09F9/30, G09G3/30

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| | JP 10-268798 A (Sanyo Electric Co., Ltd.), 09 October, 1998 (09.10.98), | |
| Y | Par. Nos. [0005], [0025] to [0052]; Figs. 1 to 4 | 1-5,7,12-16, 22-23 |
| A | Par. Nos. [0005], [0025] to [0052]; Figs. 1 to 4 & US 6307324 B1 | 6,8-11,17-21 |
| Y | JP 9-114398 A (Idemitsu Kosan Co., Ltd.), 02 May, 1997 (02.05.97), Par. No. [0038]; Fig. 2 (Family: none) | 1,4,7 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 November, 2004 (09.11.04) | 22 November, 2004 (22.11.04) |
| Name and mailing address of the ISA/ Japanese Patent Office | Authorized officer |
| Facsimile No. | Telephone No. |

Form PCT/ISA/210 (second sheet) (January 2004)

INTERNATIONAL SEARCH REPORT

International application No. PCT/JP2004/011603

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-77677 A (Sharp Corp.),<br>14 March, 2003 (14.03.03),<br>Par. No. [0025]<br>(Family: none) | 2,4,7 |
| Y | JP 53-26996 A (Tokyo Keiki Co., Ltd.),<br>13 March, 1978 (13.03.78),<br>Page 1, lower left column to page 2, upper left column; Figs. 1 to 2<br>(Family: none) | 3 |
| Y | JP 6-29514 A (Zaidan Hojin Kawamura Rikagaku Kenkyusho),<br>04 February, 1994 (04.02.94),<br>Par. Nos. [0005] to [0038]; Figs. 1 to 6<br>(Family: none) | 5 |
| Y | R.F. Karu, R.E. Sumori, "$C_{60}$ no Kagaku",<br>Nikkei Science, 01 December, 1991 (01.12.91),<br>Vol.21, No.12, pages 36 to 48 | 5 |
| <br><br>X<br>Y | JP 8-330070 A (Pioneer Electronic Corp.),<br>13 December, 1996 (13.12.96),<br>Full text; all drawings<br>Full text; all drawings<br>& US 5828181 A1 | <br><br>1,4,6<br>5,7,12-16, 22-23 |
| Y | JP 62-172395 A (NEC Corp.),<br>29 July, 1987 (29.07.87),<br>Page 2, lower left column to page 6, lower right column; Figs. 3, 5<br>(Family: none) | 12-16 |
| Y | JP 2002-328651 A (Pioneer Electronic Corp.),<br>15 November, 2002 (15.11.02),<br>Par. Nos. [0020] to [0044]; Figs. 5 to 14<br>(Family: none) | 22-23 |
| <br><br><br>X<br>Y | JP 2001-160492 A (Japan Science and Technology Corp.),<br>12 June, 2001 (12.06.01),<br>Par. Nos. [0011] to [0029]; Figs. 1 to 3<br>Par. Nos. [0011] to [0029]; Figs. 1 to 3<br>(Family: none) | <br><br><br>1,4,6<br>5,7 |
| Y | JP 58-168788 U (Hitachi, Ltd.),<br>10 November, 1983 (10.11.83),<br>Full text; all drawings<br>(Family: none) | 12-16,22-23 |

Form PCT/ISA/210 (continuation of second sheet) (January 2004)

**INTERNATIONAL SEARCH REPORT**

International application No.
PCT/JP2004/011603

C (Continuation). DOCUMENTS CONSIDERED TO BE RELEVANT

| Category* | Citation of document, with indication, where appropriate, of the relevant passages | Relevant to claim No. |
|---|---|---|
| P,A | JP 2004-93960 A (Fuji Electric Holdings Co., Ltd.), 25 March, 2004 (25.03.04), Full text; all drawings (Family: none) | 1-23 |

Form PCT/ISA/210 (continuation of second sheet) (January 2004)

**INTERNATIONAL SEARCH REPORT**

International application No.
PCT/JP2004/011603

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The inventions of claims 1-21 relate to a display comprising a switching device which is composed of a nonlinear two-terminal device electrically connected to one of the first stripe electrodes, a light-emitting unit which is electrically connected to the switching device and one of the second stripe electrodes, and a capacitor unit which is electrically connected to the switching device and the second stripe electrode in such a manner that the capacitor unit is electrically in parallel with the light-emitting unit.

The inventions of claims 22-23 relate to a method for driving a display which comprises a first electrode, (Continued to extra sheet)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest.

☒ No protest accompanied the payment of additional search fees.

Form PCT/ISA/210 (continuation of first sheet (2)) (January 2004)

**INTERNATIONAL SEARCH REPORT**

International application No.
PCT/JP2004/011603

Continuation of Box No.III of continuation of first sheet(2)

a second electrode, a rectifier device electrically connected to the first electrode, a light-emitting unit which is electrically connected to the rectifier device and the second electrode, and a capacitor unit which is electrically connected to the rectifier device and the second electrode in such a manner that the capacitor unit is electrically in parallel with the light-emitting unit.

The international search has been carried out on claims 1-21 as "the invention first mentioned (main invention)". The result of the search has revealed that the technical feature of the main invention is not novel since it is disclosed as a prior art in documents such as JP 58-168788 U, 10 November, 1983 (10.11.83). Consequently, the technical feature of the main invention cannot be considered as "a special technical feature" within the meaning of PCT Rule 13.2, second sentence, and there is no technical relationship between these two inventions involving one or more of the same or corresponding special technical features.

This international application is thus considered to contain two inventions which do not satisfy the requirement of unity of invention.

Form PCT/ISA/210 (extra sheet) (January 2004)